# EUROPEAN PATENT SPECIFICATION

(11) **EP 4 601 437 B1**
(45) Date of publication and mention of the grant of the patent: **02.09.2026**
(21) Application number: 25154694.1
(22) Date of filing: 29.01.2025
(51) Int. Cl.: H10F 77/20, H10F 71/00

(54) **METHOD FOR PREPARING A SOLAR CELL**
VERFAHREN ZUR HERSTELLUNG EINER SOLARZELLE
PROCÉDÉ DE PRÉPARATION D'UNE CELLULE SOLAIRE

(30) Priority: 07.02.2024 CN 202410175696; 07.02.2024 CN 202410175593
(43) Date of publication of application: 13.08.2025
(73) Proprietor: Jinko Solar (Haining) Co., Ltd., Haining City, Zhejiang 314415 (CN)
(72) Inventor: QIU, Caijie, Haining City, 314415 (CN); ZHAO, Shijie, Haining City, 314415 (CN); LI, Wenqi, Haining City, 314415 (CN); XING, Chengpeng, Haining City, 314415 (CN); ZHANG, Tingting, Haining City, 314415 (CN); YANG, Jie, Haining City, 314415 (CN); ZHENG, Peiting, Haining City, 314415 (CN)
(74) Representative: Balder IP Law, S.L.

(56) References cited:
- CN-A- 116 705 903
- CN-A- 117 727 838
- CN-U- 222 582 882
- US-A1- 2013 056 051

## Description

### TECHNICAL FIELD

The embodiments of the present disclosure relate to the field of solar cells, in particular to a solar cell, a method for preparing the solar cell and a photovoltaic module. The invention relates to a method for preparing a solar cell.

### BACKGROUND

Solar cells have good photoelectric conversion ability. In solar cells, multiple grid lines need to be formed on a surface of a cell sheet, so as to collect the current generated by the cell sheet.

Laser-assisted sintering technology is also known as laser-enhanced contact optimization (LECO). The main working principle of LECO technology is: exciting charge carriers by using high-intensity laser to irradiate the cell sheet, and applying a reverse voltage to the grid lines, thus generating local current of several amperes. The grid lines at the laser irradiating position are sintered to cause mutual diffusion between metal paste and the substrate of the cell sheet, which is beneficial to reducing the contact resistance between the grid lines and the semiconductor substrate.

US20130056051A1 discloses a solar cell and a manufacturing method for the solar cell. A solar cell is formed to have a silicon semiconductor substrate of a first conductive type; an emitter layer having a second conductive type opposite the first conductive type and formed on a first surface of the silicon semiconductor substrate; a back surface field layer having the first conductive type and formed on a second surface of the silicon semiconductor substrate opposite to the first surface; and wherein the emitter layer includes at least a first shallow doping area and the back surface field layer includes at least a second shallow doping area, and wherein a thickness of the first shallow doping area of the emitter layer is different from a thickness of the second shallow doping area of the back surface field layer.

CN116705903A discloses a laser sintering method for crystalline silicon solar cell. The laser sintering method comprises the following steps of: preparing the crystalline silicon solar cell with patterned metal grid lines on the front surface and the rear surface in advance; Drying the metal gate lines on the front and back surfaces of the crystalline silicon solar cell to volatilize the organic material in the metal gate lines to solidify the metal gate lines; Irradiating the metal gate lines on the front and back surfaces of the crystalline silicon solar cell with laser, and loading forward bias on the metal gate lines to sinter the metal gate lines; The crystalline silicon solar cell is an N-type cell; The forward bias voltage is 1.0-15.0 V, and the loading time is 0.1-2.5 s. The method can significantly reduce the peak power of laser sintering, shorten the sintering time, expand the process window, reduce the requirements for the stability of the laser system, and improve the metallization performance of the battery; In addition, the contact performance, the processing efficiency and the productivity are considered.

### SUMMARY

The invention is set out in the appended set of claims. The invention provides the method for preparing a solar cell recited in claim 1.

A solar cell, a method for preparing the same, and a photovoltaic module are provided according to the embodiments of the present disclosure, which are at least beneficial to improving the efficiency of the solar cell.

According to the invention, a method for preparing a solar cell is provided, which includes:
providing a cell sheet, where the cell sheet includes a first surface and a second surface opposite to each other, a plurality of first grid lines arranged on the first surface, and a plurality of second grid lines arranged on the second surface, where orthogonal projections of the first grid lines on the first surface do not overlap with orthogonal projections of the second grid lines on the first surface; performing a first laser processing on the first surface on two sides of a respective first grid line of the plurality of first grid lines, and applying a first reverse current between the plurality of first grid lines and the plurality of second grid lines, where a ratio of laser power of the first laser processing to preset power ranges from 1 to 1.1, and a ratio of the first reverse current to a preset current ranges from 1 to 1.25. The preset power and the preset current are respectively a laser power and a reverse current corresponding to breaking down PN junctions between the plurality of first grid lines and the plurality of second grid lines during performing laser processing on the plurality of first grid lines in a test case that the orthogonal projections of the plurality of first grid lines on the first surface overlapping with the orthogonal projections of the plurality of second grid lines on the first surface.

In some embodiments, the first surface on two sides of the respective first grid line includes laser processing regions and non-laser processing regions, which are alternatingly arranged in an extending direction of the respective first grid line. Performing the first laser processing on the first surface on two sides of the respective first grid line of the plurality of first grid lines includes: performing the first laser processing only on the laser processing regions on the two sides of the respective first grid line.

In some embodiments, in the extending direction of the respective first grid line, a ratio of a total length of the laser processing regions to a total length of the non-laser processing regions ranges from 2:1 to 4:1.

In some embodiments, in the extending direction of the respective first grid line, a length of a single laser processing region of the laser processing regions ranges from 1 µm to 5 µm, and a length of a single non-laser processing region of the non-laser processing regions ranges from 3 µm to 7 µm.

In some embodiments, during performing the first laser processing on the first surface on two sides of the respective first grid line of the plurality of first grid lines, the method further includes: performing the first laser processing on the respective first grid line.

In some embodiments, the first surface includes a plurality of first laser regions and a plurality of second laser regions, two of the plurality of first laser regions are located on the two sides of the respective first grid line in a direction perpendicular to an extending direction of the respective first grid line, two of the plurality of second laser regions are located on sides of the two first laser regions away from the respective first grid line, and an orthogonal projection of a respective grid line of the plurality of second grid lines on the first surface is located in a respective second laser region of the plurality of second laser regions. Performing the first laser processing on the first surface on two sides of the respective first grid line of the plurality of first grid lines includes: performing the first laser processing on the plurality of first laser regions. After performing the first laser processing, the method further includes: performing a second laser processing on the plurality of second laser regions, and applying a second reverse current between the plurality of first grid lines and the plurality of second grid lines. Laser power of the second laser processing is greater than laser power of the first laser processing, and the second reverse current is greater than the first reverse current.

In some embodiments, a respective first laser region of the two first laser regions includes laser processing regions and non-laser processing regions, which are alternatingly arranged in the extending direction of the respective first grid line. Performing the first laser processing on the plurality of first laser regions includes: performing the first laser processing only on the laser processing regions of the respective first laser region. Performing the second laser processing on the plurality of second laser regions includes: performing the second laser processing on all the second laser regions.

In some embodiments, in the direction perpendicular to the extending direction of the respective first grid line, a width of a single second laser region of the respective second laser regions is equal to a width of a respective second grid line.

In some embodiments, in the direction perpendicular to the respective first grid line, widths of the two first laser regions on two sides of the respective second laser regions are equal.

In some embodiments, in the direction perpendicular to the extending direction of the respective first grid line, a ratio of a width of a respective first laser region of the two first laser regions to a width of the respective second laser region ranges from 0.6 to 1.6.

In some embodiments, in the direction perpendicular to the extending direction of the respective first grid line, the width of the respective first laser region ranges from 60 µm to 100 µm.

In some embodiments, the preset power and the preset current are obtained by testing a test cell sheet. The test cell sheet includes a front surface and a back surface opposite to each other, front grid lines arranged on the front surface, and back grid lines arranged on the back surface, wherein orthogonal projections of the front grid lines on the front surface completely overlap with orthogonal projections of the back grid lines on the front surface. Performing laser processing on a surface on two sides of each of the front grid lines of the test cell sheet, and applying a reverse current between the front grid lines and the back grid lines, to break down PN junctions between the front grid lines and the back grid lines, wherein laser power and the reverse current corresponding to breaking down the PN junctions are obtained as the preset power and the preset current.

In some embodiments, the ratio of the laser power of the first laser processing to the preset power is 1, and the ratio of the first reverse current to the preset current is greater than 1.

In some embodiments, the ratio of the first reverse current to the preset current is 1, and the ratio of the laser power of the first laser processing to the preset power is greater than 1.

In some embodiments, distances of an orthogonal projection of any respective second grid line of the plurality of second grid lines on the first surface to orthogonal projections of two adjacent first grid lines on the first surface are equal.

In some embodiments, a number of the plurality of second grid lines is twice of a number of the plurality of first grid lines, and any respective first grid line of the plurality of first grid lines is arranged at a corresponding position in the middle of two adjacent second grid lines of the plurality of second grid lines at intervals from the two adjacent second grid lines.

In some embodiments, a number of the plurality of second grid lines is equal to a number of the plurality of first grid lines, and any respective first grid line of the plurality of first grid lines is located in a region between two adjacent second grid lines of the plurality of second grid lines.

In some embodiments, in a direction perpendicular to the extending direction of the respective first grid line, a width of a single laser processing region of the laser processing regions is equal to a spacing between any two adjacent first grid lines of the plurality of first grid lines.

In some embodiments, in a direction perpendicular to the extending direction of the respective first grid line, a width of a single laser processing region of the laser processing regions is less than or equal to half of a spacing between any two adjacent first grid lines of the plurality of first grid lines.

A solar cell is described, which is prepared by the method for preparing the solar cell according to any one of the above.

A photovoltaic module is described, which includes: at least one solar cell according to any one of the above embodiments, an adhesive film, covering a surface of the solar cell, and a cover plate, covering a surface of the adhesive film away from the solar cell.

The technical solution provided by the embodiments of the present disclosure has at least the following advantages.

In the method for preparing the solar cell according to the embodiments of the present disclosure, the laser processing is performed on the first surface on the two sides of the respective first grid line on the cell sheet, and the reverse current is applied between the first grid lines and the second grid lines. Under the irradiation of laser, a large number of carriers are generated in the region on the two sides of the respective first grid line in the cell sheet. At the same time, due to the reverse current, the electrons in the carriers can be trapped on the surface of the cell sheet in contact with the first grid line. The electrons react with the first grid line, causing the metal ions in the first grid line to precipitate metal micelles. The metal micelles form conductive contact points between the first grid line and the semiconductor material inside the sheet, which can reduce the contact resistance between the first grid line and the semiconductor material, and is beneficial to improving the filling factor of the solar cell, thereby enhancing the photoelectric conversion efficiency of the solar cell. In addition, since the orthogonal projections of the first grid lines on the first surface do not overlap with the orthogonal projections of the second grid lines on the first surface, the resistance between the first grid lines and the second grid lines is larger than the resistance when the orthogonal projections of the first grid lines on the first surface overlap with the orthogonal projections of the second grid lines on the first surface, so that the laser power with higher preset power and reverse current with larger preset current can be used in the first laser processing to promote the laser sintering of the first grid lines, which is beneficial to better ohmic contact between the first grid lines and the semiconductor material in the cell sheet, and improving the filling factor of the solar cell, thereby improving the efficiency of the solar cell. By setting the ratio of the laser power of the first laser processing to the preset power to range from 1 to 1.1, and the ratio of the first reverse current to the preset current to range from 1 to 1.25, the problem that the PN junctions between the first grid lines and the second grid lines are broken down can be avoided, and the first grid lines have a good sintering degree, so as to avoid the problem that the efficiency of the solar cell is reduced due to excessive sintering or low sintering degree.

### BRIEF DESCRIPTION OF THE DRAWINGS

One or more embodiments are described by way of the corresponding figures in the accompanying drawings, and the exemplary description does not constitute limitations on the embodiments. Unless otherwise specified, the figures in the drawings do not constitute the scale limitation. To describe the technical solutions of the embodiments of the present disclosure or the related art more clearly, the accompanying drawings needed in the embodiments are briefly described below. Apparently, the accompanying drawings in the following description show only some embodiments of the present disclosure, and other drawings can be obtained by those skilled in the art according to these accompanying drawings without creative efforts.
FIG. 1 is a schematic structural diagram of an exemplary cell sheet according to an embodiment of the present disclosure, which is for illustrative purposes only and not encompassed by the scope of the appended claims.
FIG. 2 is a flowchart corresponding to a method for preparing a solar cell according to an embodiment of the present disclosure.
FIG. 3 is a schematic structural diagram corresponding to an operation of providing a cell sheet in the method for preparing the solar cell according to an embodiment of the present disclosure.
FIG. 4 is a top view of a cell sheet according to an embodiment of the present disclosure.
FIG. 5 is a top view of another cell sheet according to an embodiment of the present disclosure.
FIG. 6 is a schematic cross-sectional view of the cell sheet taken along line C-C1 in FIG. 5;
FIG. 7 is a flowchart corresponding to a method for preparing a solar cell according to an embodiment of the present disclosure.
FIG. 8 is a schematic structural diagram corresponding to an operation of providing a cell sheet in the method for preparing the cell body according to an embodiment of the present disclosure.
FIG. 9 is a schematic structural diagram of a cell sheet according to an embodiment of the present disclosure.
FIG. 10 is a schematic structural diagram of another cell sheet according to an embodiment of the present disclosure.
FIG. 11 is a top view of a cell sheet according to an embodiment of the present disclosure.
FIG. 12 is a top view of another cell sheet according to an embodiment of the present disclosure.
FIG. 13 is a schematic structural diagram of a photovoltaic module according to an embodiment of the present disclosure.

### DETAILED DESCRIPTION OF THE EMBODIMENTS

It can be known from the background that when grid lines are formed on a surface of a cell sheet by laser-assisted sintering technology, a PN junction in a substrate (a boundary or an interface between the P-type semiconductor material and the N-type semiconductor material in the substrate) is prone to breakdown under the influence of laser or reverse voltage, which leads to the blackening of the cell sheet in the electroluminescent image and affects the efficiency of the cell sheet.

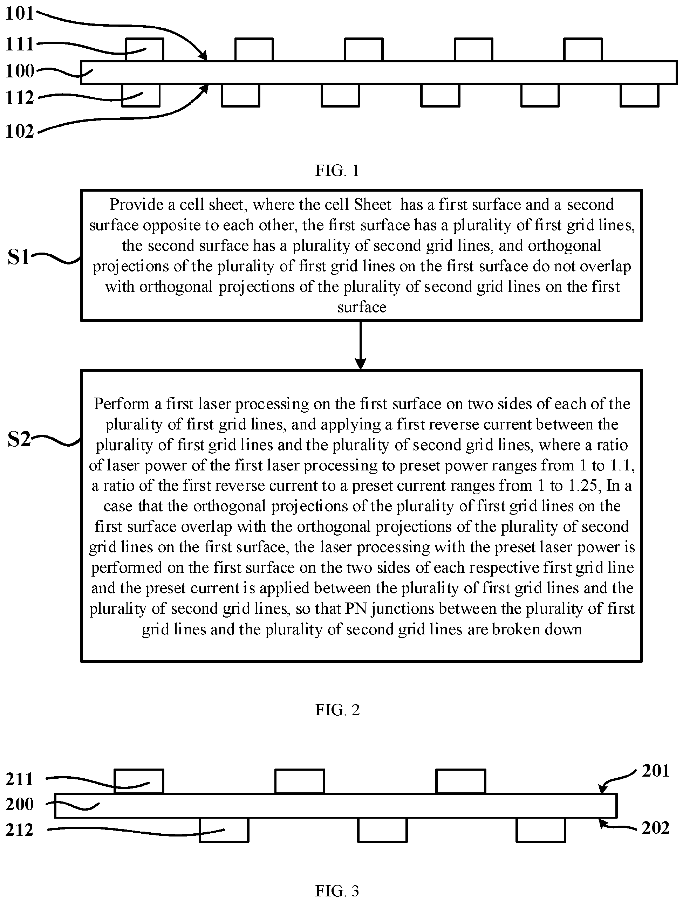

FIG. 1 is a schematic structural diagram of an exemplary cell sheet provided in an embodiment of the present application, which is provided for illustrative purposes only and does not fall within the scope of the appended claims.

Referring to FIG. 1, an exemplary cell sheet 100 (which is provided for illustrative purposes only and does not fall within the scope of the appended claims) has a first surface 101 and a second surface 102 opposite to each other. The first surface 101 of the cell sheet 100 has first grid lines 111, and the second surface 102 of the cell sheet 100 has second grid lines 112 with a polarity different from the first grid lines 111. For example, the first gate lines 111 serve as one of the positive electrode or the negative electrode, and the second gate lines 112 serve as the other of the positive electrode or the negative electrode. Since the number of the first grid lines 111 and the second grid lines 112 on the surfaces on two sides of the cell sheet 100 may be unequal, in a direction perpendicular to the first surface 101, some of the first grid lines 111 and the second grid lines 112 may be aligned, some of the first grid lines 111 and the second grid lines 112 may be partially aligned, and some of the first grid lines 111 and the second grid lines 112 may be misaligned. Different alignment states of the first grid lines 111 and the second grid lines 112 lead to different resistances between the first grid lines 111 and the second grid lines 112 when a reverse current is applied between the first grid lines 111 and the second grid lines 112. If the same laser power is applied to all the first surface 101 of the cell sheet 100 and the same reverse current is applied to all the first grid lines 111 and the second grid lines, the resistance between the first grid line 111 and the second grid line 112 when the first grid line 111 and the second grid line 112 are aligned or partially aligned is smaller than the resistance when the first grid line 111 and the second grid line 112 are misaligned. That is to say, when an orthogonal projection of the first grid line 111 on the first surface 101 and an orthogonal projection of the second grid line 112 on the first surface 101 at least partially overlap, a PN junction between the first grid line 111 and the second grid line 112 is more likely to be broken down, which leads to the problem of blackening in the electroluminescent image of the cell sheet 100, thereby affecting the efficiency of the solar cell.

A method for preparing a solar cell is provided according to an embodiment of the present disclosure, which is at least beneficial to improving the efficiency of the solar cell.

Hereinafter, embodiments of the present application will be described in detail with reference to the attached drawings. However, those skilled in the art should understand that in various embodiments of the present disclosure, many technical details are put forward to help readers better understand the present disclosure. However, even without these technical details and various changes and modifications based on the following embodiments, the technical solution claimed in the present disclosure can be realized. The method for preparing the solar cell provided by this embodiment will be described in detail with the attached drawings.

FIG. 2 is a flowchart corresponding to a method for preparing a solar cell according to an embodiment of the present disclosure. FIG. 3 is a structural diagram corresponding to an operation of providing a cell sheet in the method for preparing the solar cell according to an embodiment of the present disclosure.

Referring to FIG. 2, the method for preparing the solar cell includes the following operations.

At S1, referring to FIG. 3, a cell sheet 200 is provided. The cell sheet 200 has a first surface 201 and a second surface 202 opposite to each other. The first surface 201 has a plurality of first grid lines 211, the second surface 202 has a plurality of second grid lines 212, and orthogonal projections of the plurality of first grid lines 211 on the first surface 201 do not overlap with orthogonal projections of the plurality of second grid lines 212 on the first surface 201.

In some embodiments, the solar cell 200 may be one of a Passivated Emission and Rear (PERC) cell, a Passivated Emission and Rear Completely diffused (PERT) cell, a Tunnel Oxide Passivated Contact (TOPCON) cell, or a Heterojunction Technology (HIT/HJT) cell.

In some embodiments, the solar cell may be a single-sided cell, with the first surface 201 serving as a light receiving surface for receiving incident light, and the second surface 202 serving as a backlight surface. In some embodiments, the solar cell 200 may be a bifacial cell, and both the first surface 201 and the second surface 202 may serve as light receiving surfaces, which are configured to receive incident light.

In some embodiments, the cell sheet may include a first passivation layer, a substrate and a second passivation layer stacked in sequence, with a surface of the first passivation layer away from the substrate as the first surface, and a surface of the second passivation layer away from the substrate as the second surface. The first grid lines are located on the surface of the first passivation layer away from the substrate, and the second grid lines are located on the surface of the second passivation layer away from the substrate. The substrate is configured to receive incident light and generate photo-generated carriers. The first passivation layer and the second passivation layer can prevent oxidation or corrosion of the surface of the substrate, so as to improve the stability and service life of the cell sheet.

In some embodiments, the material of the substrate may be at least one of monocrystalline silicon, polycrystalline silicon, amorphous silicon or microcrystalline silicon. In some embodiments, the materials of the first passivation layer and the second passivation layer may include one or more of silicon oxide, silicon nitride, silicon oxynitride, silicon oxy-carbonitride, titanium oxide, hafnium oxide or aluminum oxide.

In some embodiments, the substrate may be an N-type semiconductor substrate or a P-type semiconductor substrate. The N-type semiconductor substrate is doped with a N-type doping element, and the N-type doping element may be any one of V-group elements such as phosphorus (P), bismuth (Bi), antimony (Sb) or arsenic (As). The P-type semiconductor substrate is doped with a P-type element, and the P-type doping element may be any one of III-group elements such as boron (b), aluminum (al), gallium (ga) or indium (in).

The substrate may have an emitter located on a side of the substrate close to the first passivation layer and in contact with the first passivation layer. The type of the doping element of the emitter is opposite to the type of the doping element inside the substrate, thus forming PN junctions between the emitter and the substrate. For example, if the doping element in the substrate is a P-type doping element, then the doping element in the emitter is an N-type doping element. If the doping element in the substrate is an N-type doping element, then the doping element in the emitter is a P-type doping element. PN junctions can receive incident light irradiated to the surface of the substrate and generate electron hole pairs. For example, when the substrate is an N-type substrate, separated electrons move into the substrate and separated holes move into the emitter, thus forming a current.

In some embodiments, a surface on at least one side of the substrate may have a textured structure, such as a textured surface with a pyramid structure, so that the textured structure can enhance the absorption and utilization rate of the substrate for incident light, thereby being beneficial to improving the light conversion efficiency of the cell sheet. If the solar cell is a single-sided cell, the textured surface may be formed only on one side of the substrate, and the other side surface of the substrate may be a polished surface, that is, the polished surface of the substrate is flatter than the textured surface. It should be noted that for the single-sided cell, a textured surface may also be formed on both sides of the substrate. If the solar cell is a bifacial cell, a textured surface may be formed on both sides of the substrate.

In some embodiments, the material of the first passivation layer may include at least one of aluminum oxide, silicon oxide, silicon nitride or silicon oxynitride. The first passivation layer may be a single-layer structure or a laminated structure, for example, the single-layer structure may be a single-layer aluminum oxide film layer, a single-layer silicon oxide film layer, a single-layer silicon nitride film layer or a single-layer silicon oxynitride film layer. The laminated structure may include at least two layers of aluminum oxide film layer, silicon oxide film layer, silicon nitride film layer or silicon oxynitride film layer.

In some embodiments, the material of the second passivation layer may include at least one of aluminum oxide, silicon oxide, silicon nitride or silicon oxynitride. The second passivation layer may be a single-layer structure or a laminated structure, for example, the single-layer structure may be a single-layer aluminum oxide film layer, a single-layer silicon oxide film layer, a single-layer silicon nitride film layer or a single-layer silicon oxynitride film layer. The laminated structure may include at least two layers of aluminum oxide film layer, silicon oxide film layer, silicon nitride film layer or silicon oxynitride film layer.

In some embodiments, the second passivation layer may include a tunneling layer, a doped conductive layer and an anti-reflection layer which are sequentially stacked along a direction away from the surface of the substrate. The tunneling layer and the doped conductive layer are configured to form a passivation contact structure, and the tunneling layer can play a role in chemical passivation. Due to interface state defects on the surface of the substrate, the tunneling layer can saturate the dangling bonds on the surface of the substrate, reduce the density of defect states on the surface of the substrate, and reduce the recombination center on the surface of the substrate to reduce the recombination rate of the carriers, so that the interface state density of the surface of the substrate is large. The increase of the interface state density can promote the recombination of photo-generated carriers, increase the filling factor, short-circuit current and open-circuit voltage of the solar cell, and improve the photoelectric conversion efficiency of the solar cell. The doped conductive layer can have a field passivation effect, and the doped conductive layer can form an electrostatic field, so that minority carriers escape from the interface, the concentration of minority carriers is reduced, the recombination rate of the carriers at the interface of the substrate is low, the open-circuit voltage, short-circuit current and filling factor of the solar cell are improved, and the photoelectric conversion efficiency of the solar cell is improved. The anti-reflection layer can reduce the reflectivity of sunlight on the surface of the solar cell, so that more light can be absorbed and converted into electric energy, thereby improving the light absorption efficiency of the solar cell. In addition, the anti-reflection layer can protect the internal structure of the cell sheet, protect the cell sheet from environmental pollution, and improve the stability of the solar cell.

The material of the tunneling layer may include at least one of silicon oxide, silicon nitride, silicon oxynitride, silicon carbide or magnesium fluoride.

The material of the doped conductive layer may be at least one of amorphous silicon, polysilicon or silicon carbide. The doped conductive layer has the same doping element as the substrate, and the type of the doping element of the substrate is P-type, so the type of the doping element in the doped conductive layer is also P-type. If the type of the doping element of the substrate is N-type, the type of the doping element in the doped conductive layer is also N-type.

The material of the anti-reflection layer may be one of silicon oxide, aluminum oxide, silicon nitride or silicon oxynitride.

In some embodiments, distances from an orthogonal projection of a second grid line 212 on the first surface 201 to orthogonal projections of two adjacent first grid lines 211 on the first surface 201 are equal. That is, the second grid line 212 is located in the middle of the two adjacent first grid lines 211, so that the distances from the second grid line 212 to the two adjacent first grid lines 211 are equal, and the resistance between the second grid line 212 and the corresponding two adjacent first grid lines 211 are equal. Therefore, when the first laser processing is performed on the first surface 201 on two sides of the respective first grid line 211 and the first reverse current is applied between the first grid lines 211 and the second grid lines 212, it is beneficial to maintaining similar sintering degrees of different first grid lines 211, thereby improving the uniformity of performance of the solar cell.

In some embodiments, the distances from the orthogonal projection of the second grid line 212 on the first surface 201 to the orthogonal projections of the two adjacent first grid lines 211 on the first surface 201 may also be unequal.

In some embodiments, the number of the first grid lines and the number of the second grid lines may be different. For example, the number of the second grid lines may be twice the number of the first grid lines. Specifically, when the number of first grid lines on the first surface is 160, the spacing between any two first grid lines may range from 1.1 mm to 1.5 mm, such as 1.1 mm, 1.12 mm, 1.33 mm, 1.45 mm or 1.5 mm. The number of second grid lines on the second surface may be 320, and the spacing between any two second grid lines may be 1/2 to 1/3 of the spacing between any two first grid lines, such as 1/2, 1/2.3, 1/2.5, 1/2.8 or 1/3. When the number of the second grid lines is twice the number of the first grid lines, any first grid line may be arranged at a corresponding position in the middle of two adjacent second grid lines disposed at intervals, so that the first grid lines and the second grid lines are completely staggered along a direction perpendicular to the first surface.

In some embodiments, the number of the first grid lines and the number of the second grid lines may also be equal. For example, the number of the first grid lines on the first surface may be 148, and the spacing between any two first grid lines may range from 1.1 mm to 1.5 mm, such as 1.1 mm, 1.12 mm, 1.33 mm, 1.45 mm or 1.5 mm. The number of second grid lines on the second surface may be 148, and the spacing between any two second grid lines may range from 1.1 mm to 1.5 mm, for example, 1.1 mm, 1.12 mm, 1.33 mm, 1.45 mm or 1.5 mm. When printing the first grid lines and second grid lines, each first grid line can be located in a region between two adjacent second grid lines, so that the first grid lines and the second grid lines are completely staggered.

At S2, a first laser processing is performed on the first surface 201 on two sides of each respective first grid line 211 of the plurality of first grid lines 211, and a first reverse current is applied between the plurality of first grid lines 211 and the plurality of second grid lines 212. A ratio of laser power of the first laser processing to preset power ranges from 1 to 1.1, such as 1, 1.01, 1.02, 1.03, 1.04, 1.05, 1.06, 1.07, 1.08, 1.09, or 1.1. A ratio of the first reverse current to a preset current ranges from 1 to 1.25, such as 1, 1.03, 1.05, 1.07, 1.1, 1.14, 1.18, 1.2, 1.23, or 1.25. The preset laser power and the preset current are a laser power and a reverse current corresponding to breaking down PN junctions between the plurality of first grid lines and the plurality of second grid lines during performing laser processing on the plurality of first grid lines in a case that the orthogonal projections of the plurality of first grid lines on the first surface overlapping with the orthogonal projections of the plurality of second grid lines on the first surface.

In some embodiments, the preset power and the preset current may be obtained by testing a test cell sheet. For example, a front surface and a back surface of the test cell sheet include front grid lines and back grid lines respectively, and orthogonal projections of the front grid lines on the front surface completely overlap with orthogonal projections of the back grid lines on the front surface. The manufacturing process of the test cell sheet is the same as the manufacturing process of the cell sheet. By performing laser processing on two sides of each respective front grid line of the front grid lines of the test cell sheet, and applying a reverse current between the front grid lines and the back grid lines, PN junctions between the front grid lines and the back grid lines are broken down. The laser power and the reverse current corresponding to breaking down the PN junctions are obtained as the preset power and the preset current.

It should be understood that when the ratio of the laser power of the first laser processing to the preset power is 1, the ratio of the first reverse current to the preset current is greater than 1, so as to promote the first grid lines 211 to have a better sintering degree. When the ratio of the first reverse current to the preset current is 1, the ratio of the laser power of the first laser processing to the preset power is greater than 1, so as to promote the first grid lines 211 to have a better sintering degree.

In the method for preparing the solar cell provided by this embodiment of the present disclosure, the laser processing is performed on the first surface 201 on the two sides of the respective first grid line 211 on the cell sheet 200, and the reverse current is applied between the first grid lines 211 and the second grid lines 212. Under the irradiation of laser, a large number of carriers are generated in the region on the two sides of the first grid line 211 in the cell sheet 200. At the same time, due to the reverse current, the electrons in the carriers can be trapped on the surface of the cell sheet 200 in contact with the first grid line 211. The electrons react with the first grid line 211, causing the metal ions in the first grid line 211 to precipitate metal micelles. The metal micelles form conductive contact points between the first grid line 211 and the semiconductor material inside the cell sheet 200, which can reduce the contact resistance between the first grid line 211 and the semiconductor material, and is beneficial to improving the filling factor of the solar cell, thereby enhancing the photoelectric conversion efficiency of the solar cell. In addition, since the orthogonal projections of the first grid lines 211 on the first surface 201 do not overlap with the orthogonal projections of the second grid lines 212 on the first surface 201, the resistance between the first grid lines 211 and the second grid lines 212 is larger than the resistance when the orthogonal projections of the first grid lines 211 on the first surface 201 overlap with the orthogonal projections of the second grid lines 212 on the first surface 201, so that the laser power with higher preset power and the reverse current with larger preset current can be used in the first laser processing to promote the laser sintering of the first grid lines 211, which is beneficial to better ohmic contact between the first grid lines 211 and the semiconductor material in the cell sheet 200, and improving the filling factor of the solar cell, thereby improving the efficiency of the solar cell. By setting the ratio of the laser power of the first laser processing to the preset power to range from 1 to 1.1, and the ratio of the first reverse current to the preset current to range from 1 to 1.25, the problem that the PN junctions between the first grid lines 211 and the second grid lines 212 are broken down can be avoided, and the first grid lines 211 have a good sintering degree, so as to avoid the problem that the efficiency of the solar cell is reduced due to excessive sintering or low sintering degree.

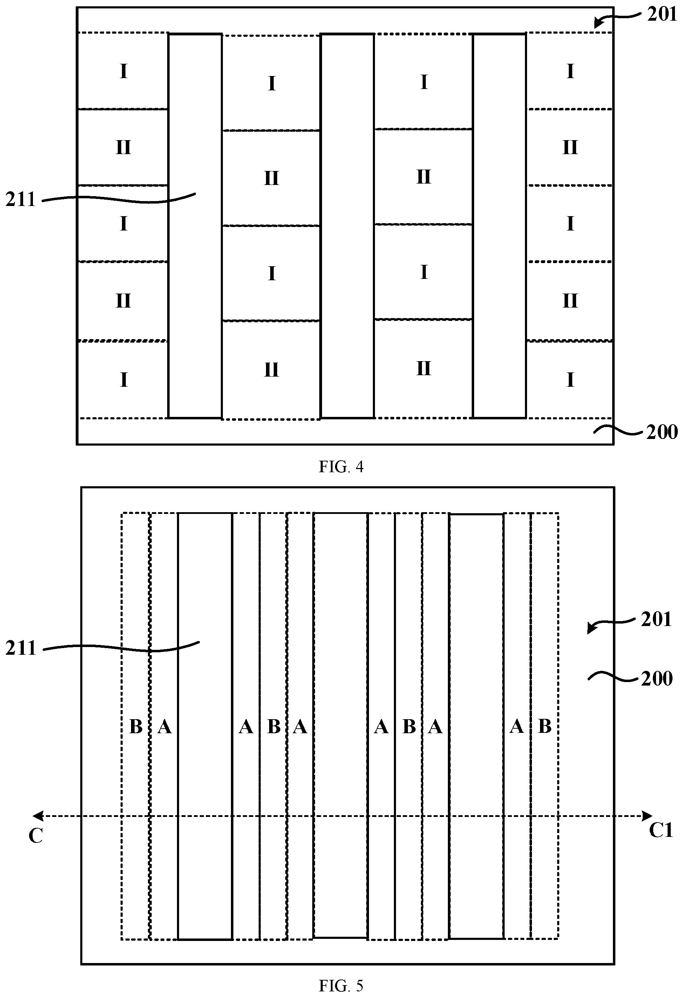

FIG. 4 is a top view of a cell sheet according to an embodiment of the present disclosure.

Referring to FIG. 4, in some embodiments, in an extending direction of a first grid line 211, the first surface 201 on two sides of the first grid line 211 include laser processing regions I and non-laser processing regions II which are alternatingly arranged. Performing the first laser processing on the first surface 201 on two sides of the first grid line 211 includes: performing the first laser processing only on the laser processing regions I on the two sides of the first grid line 211.

During the first laser processing, the first surface 201 on the two sides of the first grid line 211 is subjected to intermittent laser processing by combining virtual and real irradiation, and the laser processing regions I are irradiated, while the non-laser processing regions II are not irradiated, so that a large number of carriers are generated in the laser processing regions I, and no carriers is generated in the non-laser processing region II or less carriers is generated due to the radiation in the laser processing regions I. In this way, the number of generated carriers can be precisely controlled by the irradiation mode of patterning the first laser irradiation regions I, which is beneficial to controlling the sintering degree of the first grid line 211.

In some embodiments, the number and arrangement of laser processing regions I and non-laser processing regions II may be the same or different on both sides along a direction perpendicular to the extending direction of the first grid line 211.

In FIG. 4, for example, in the direction perpendicular to the extending direction of the first grid line 211, a width of each laser processing region I is equal to the spacing between any two adjacent first grid lines 211, so that the two adjacent first grid lines 211 jointly use the generated carriers in the same laser processing region I during the first laser processing process. In some embodiments, in the direction perpendicular to the extending direction of the first grid line, the width of each laser processing region can be less than or equal to 1/2 of the spacing between any two adjacent first grid lines, so that different first grid lines can respectively utilize the carriers generated by the respective laser processing regions during the first laser processing process, thus being beneficial to setting areas of the corresponding laser processing regions for different first grid lines respectively, and being beneficial to regulating and controlling the number of generated carriers.

In some embodiments, in the extending direction of the first grid line 211, a ratio of a total length of the non-laser processing regions II to a total length of the laser processing regions I ranges from 2:1 to 4:1, such as 2:1, 2.3:1, 3:1, 3.6:1, or 4:1.

In some embodiments, in the extending direction of the first grid line 211, a length of each laser processing region I ranges from 1 µm to 5 µm, such as 1 µm, 1.5 µm, 2 µm, 2.4 µm, 3 µm, 3.6 µm, 4 µm, 4.7 µm or 5 µm. A length of each non-laser processing region II ranges from 3 µm to 7 µm, such as 3 µm, 3.3 µm, 4 µm, 4.6 µm, 5 µm, 5.9 µm, 6 µm, 6.5 µm or 7 µm.

In some embodiments, during performing a first laser processing on the first surface 201 on two sides of each respective first grid line 21 of the plurality of first grid lines 201, the method further includes: performing the first laser processing on the respective first grid line 211. It should be understood that when the size of the laser spot processed by the first laser is large, the laser processed by the first laser can also be irradiated on the first grid line 211. Due to the smaller size of the laser spot, the corresponding spot is prone to generate higher energy density, resulting in excessive damage to the surface of the material. When the size of the laser spot is large, the laser can be prevented from damaging to the first grid line 211, so that the laser processed by the first laser can be hit on the first grid line 211.

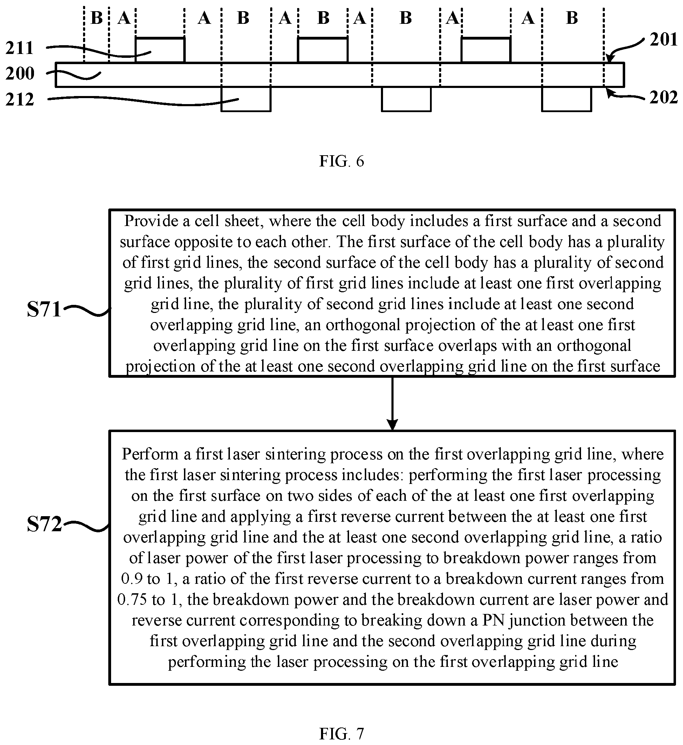

FIG. 5 is a top view of another cell sheet according to an embodiment of the present disclosure. FIG. 6 is a schematic cross-sectional view of the cell sheet taken along line C-C1 in FIG. 5.

Referring to FIG. 5 and FIG. 6, in some embodiments, the first surface 201 includes a plurality of first laser regions A and a plurality of second laser regions B. Two of the plurality of first laser regions A are located on two sides of the respective first grid line 201 in the direction perpendicular to the extending direction of the respective first grid line 211, two of the plurality of second laser regions B are located on sides of the two first laser regions A away from the respective first grid line 211, and an orthogonal projection of each respective second grid line 212 of the plurality of second grid lines 212 on the first surface 201 is located in a respective second laser region B. Performing the first laser processing on the first surface 201 on two sides of each respective first grid line 211 of the plurality of first grid lines 211 includes: performing the first laser processing on the plurality of first laser regions A. After performing the first laser processing, the method further includes: performing a second laser processing on the plurality of second laser regions B, and applying a second reverse current between the plurality of first grid lines 211 and the plurality of second grid lines 212. Laser power of the second laser processing is greater than the laser power of the first laser processing, and the second reverse current is greater than the first reverse current.

The laser sintering of the first grid line 211 is performed in two steps. The regions irradiated by the laser during the first laser processing are located on the two sides adjacent to the first grid line 211, and the regions irradiated by the laser during the second laser processing are located in the regions at intervals from the first grid line 211. In this way, the sintering degree of the first grid line 211 can be controlled more precisely, which is beneficial to adjusting the process conditions of the second laser processing according to the sintering degree of the first laser processing. Due to the interval between the first grid line 211 and the second laser regions, the carriers generated by the second laser processing reach below the first grid line 211 more slowly than the carriers generated by the first laser processing, and the corresponding laser power and second reverse current of the second laser processing can be appropriately increased compared with the process conditions of the first laser processing. In addition, since the orthogonal projection of the second grid line 212 on the first surface 201 is located in the second laser region B, the reverse current between the first grid line 211 and the second grid line 212 can interact with the carriers more quickly, thereby promoting the precipitation of metal micelles in the first grid line, and promoting the good ohmic contact between the first grid line 211 and the semiconductor material in the cell sheet 200, thereby improving the filling factor and efficiency of the solar cell.

In FIG. 5 and FIG. 6, the same second laser region B is used to generate carriers during the second laser processing between two adjacent first grid lines 211. In some embodiments, the second laser regions corresponding to different first grid lines can be arranged at intervals from each other, so as to utilize the carriers generated by different second laser regions during the second laser processing.

In some embodiments, in the extending direction of the respective first grid line, each first laser region includes laser processing regions and non-laser processing regions which are alternatingly arranged. Performing the first laser processing on the plurality of first laser regions includes: performing the first laser processing only on the laser processing regions of the respective first laser region. Performing the second laser processing on the plurality of second laser regions includes: performing the second laser processing on all the second laser regions.

That is, in the process of performing laser processing on the first grid line by two-step laser sintering, the irradiation of the first laser processing can also adopt a combination of virtual and real irradiation, which is beneficial to precisely regulating the number of generated carriers, thereby being beneficial to controlling the sintering degree of the first grid line.

In some embodiments, in the direction perpendicular to the extending direction of the respective first grid line 211, the width of the second laser region B may be equal to the width of the second grid line 212. In this way, in the direction perpendicular to the first surface 201, the positions of the second grid lines 212 can completely correspond to the positions of the second laser regions B, which is beneficial to the interaction between carriers and the reverse current, thereby promoting the laser sintering of the first grid lines 211.

In some embodiments, in the direction perpendicular to the extending direction of the respective first grid line 211, widths of the first laser regions A on two sides of the second laser region B are equal. That is, the second laser region B is located in the middle of the two adjacent first grid lines 211, and the sizes of the first laser regions A corresponding to the two adjacent first grid lines 211 are equal, which can avoid the difference in the number of carriers generated in the first laser processing or the second laser processing due to the different areas of the first laser regions A and the second laser regions B corresponding to different first grid lines 211, thereby being beneficial to regulating the number of carriers by the area irradiated by the laser.

In some embodiments, in the direction perpendicular to the extending direction of the respective first grid line 211, a ratio of a width of a single first laser region A to a width of a single second laser region B may range from 0.6 to 1.6, such as 0.6, 0.8, 1, 1.1, 1.3, 1.5, or 1.6.

In some embodiments, in the direction perpendicular to the extending direction of the respective first grid line 211, the width of a single first laser region A ranges from 60 µm to 100 µm, such as 60 µm, 70 µm, 75 µm, 80 µm, 85 µm, 90 µm, 95 µm, or 100 µm. The width of a single second laser region B ranges from 60 µm and 100 µm, such as 60 µm, 70 µm, 75 µm, 80 µm, 85 µm, 90 µm, 95 µm, or 100 µm.

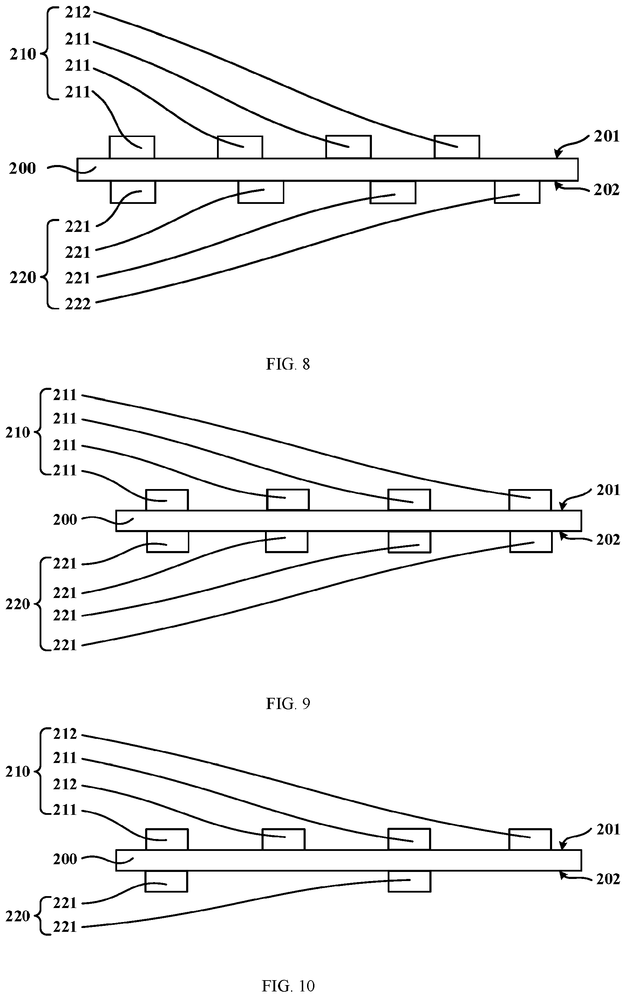

FIG. 7 is a flowchart corresponding to a method for preparing a solar cell according to an embodiment of the present disclosure. FIG. 8 is a schematic structural diagram corresponding to operations of providing a cell sheet in the method for preparing the solar cell according to an embodiment of the present disclosure.

Referring to FIG. 7, the method for preparing the solar cell includes the following operations.

At S71, referring to FIG. 8, a cell sheet 200 is provided. The cell sheet 200 includes a first surface 201 and a second surface 202 opposite to each other. The first surface 201 of the cell sheet 200 has a plurality of first grid lines 210, and the second surface 202 of the cell sheet 200 has a plurality of second grid lines 220. The plurality of first grid lines 210 include at least one first overlapping grid line 211, and the plurality of second grid lines 220 include at least one second overlapping grid line 221. An orthogonal projection of the at least one first overlapping grid line 211 on the first surface 201 overlaps with an orthogonal projection of the at least one second overlapping grid line 221 on the first surface 201.

In some embodiments, the cell sheet may include a first passivation layer, a substrate and a second passivation layer stacked in sequence, with a surface of the first passivation layer away from the substrate as the first surface, and a surface of the second passivation layer away from the substrate as the second surface. The first grid lines are located on the surface of the first passivation layer away from the substrate, and the second grid lines are located on the surface of the second passivation layer away from the substrate. The substrate is configured to receive incident light and generate photo-generated carriers. The first passivation layer and the second passivation layer can prevent oxidation or corrosion of the surface of the substrate, so as to improve the stability and service life of the solar cell.

In some embodiments, the material of the substrate may be at least one of monocrystalline silicon, polycrystalline silicon, amorphous silicon or microcrystalline silicon. In some embodiments, the materials of the first passivation layer and the second passivation layer may include one or more of silicon oxide, silicon nitride, silicon oxynitride, silicon oxy-carbonitride, titanium oxide, hafnium oxide or aluminum oxide.

In some embodiments, the substrate may be an N-type semiconductor substrate or a P-type semiconductor substrate. The N-type semiconductor substrate is doped with a N-type doping element, and the N-type doping element may be any V-group elements such as phosphorus (P), bismuth (Bi), antimony (Sb) or arsenic (As). The P-type semiconductor substrate is doped with a P-type element, and the P-type doping element may be any one of III-group elements such as boron (b), aluminum (al), gallium (ga) or indium (in).

The substrate may have an emitter located on a side of the substrate close to the first passivation layer and in contact with the first passivation layer. The type of the doping element of the emitter is opposite to the type of the doping element inside the substrate, thus forming PN junctions between the emitter and the substrate. For example, if the doping element in the substrate is a P-type doping element, then the doping element in the emitter is an N-type doping element. If the doping element in the substrate is an N-type doping element, then the doping element in the emitter is a P-type doping element. PN junctions can receive incident light irradiated to the surface of the substrate and generate electron hole pairs. For example, when the substrate is an N-type substrate, separated electrons move into the substrate and separated holes move into the emitter, thus forming a current.

In some embodiments, a surface on at least one side of the substrate may have a textured structure, such as a textured surface with a pyramid structure, so that the textured structure can enhance the absorption and utilization rate of the substrate for incident light, thereby being beneficial to improving the light conversion efficiency of the cell sheet. If the solar cell is a single-sided cell, the textured surface may be formed only on one side of the substrate, and the other side surface of the substrate may be a polished surface, that is, the polished surface of the substrate is flatter than the textured surface. It should be noted that for the single-sided cell, a textured surface may also be formed on both sides of the substrate. If the solar cell is a bifacial cell, a textured surface may be formed on both sides of the substrate.

In some embodiments, the material of the first passivation layer may include at least one of aluminum oxide, silicon oxide, silicon nitride or silicon oxynitride. The first passivation layer may be a single-layer structure or a laminated structure, for example, the single-layer structure may be a single-layer aluminum oxide film layer, a single-layer silicon oxide film layer, a single-layer silicon nitride film layer or a single-layer silicon oxynitride film layer. The laminated structure may include at least two layers of aluminum oxide film layer, silicon oxide film layer, silicon nitride film layer or silicon oxynitride film layer.

In some embodiments, the material of the second passivation layer may include at least one of aluminum oxide, silicon oxide, silicon nitride or silicon oxynitride. The second passivation layer may be a single-layer structure or a laminated structure, for example, the single-layer structure may be a single-layer aluminum oxide film layer, a single-layer silicon oxide film layer, a single-layer silicon nitride film layer or a single-layer silicon oxynitride film layer. The laminated structure may include at least two layers of aluminum oxide film layer, silicon oxide film layer, silicon nitride film layer or silicon oxynitride film layer.

In some embodiments, the second passivation layer may include a tunneling layer, a doped conductive layer and an anti-reflection layer which are sequentially stacked along a direction away from the surface of the substrate. The tunneling layer and the doped conductive layer are configured to form a passivation contact structure, and the tunneling layer can play a role in chemical passivation. Due to interface state defects on the surface of the substrate, the tunneling layer can saturate the dangling bonds on the surface of the substrate, reduce the density of defect states on the surface of the substrate, and reduce the recombination center on the surface of the substrate to reduce the recombination rate of the carriers, so that the interface state density of the surface of the substrate is large. The increase of the interface state density can promote the recombination of photo-generated carriers, increase the filling factor, short-circuit current and open-circuit voltage of the solar cell, and improve the photoelectric conversion efficiency of the solar cell. The doped conductive layer can have a field passivation effect, and the doped conductive layer can form an electrostatic field, so that minority carriers escape from the interface, the concentration of minority carriers is reduced, the recombination rate of the carriers at the interface of the substrate is low, the open-circuit voltage, short-circuit current and filling factor of the solar cell are improved, and the photoelectric conversion efficiency of the solar cell is improved. The anti-reflection layer can reduce the reflectivity of sunlight on the surface of the solar cell, so that more light can be absorbed and converted into electric energy, thereby improving the light absorption efficiency of the solar cell. In addition, the anti-reflection layer can protect the internal structure of the cell sheet, protect the cell sheet from environmental pollution, and improve the stability of the solar cell.

The material of the tunneling layer may include at least one of silicon oxide, silicon nitride, silicon oxynitride, silicon carbide or magnesium fluoride.

The material of the doped conductive layer may be at least one of amorphous silicon, polysilicon or silicon carbide. The doped conductive layer has the same doping element as the substrate, and the type of the doping element of the substrate is P-type, so the type of the doping element in the doped conductive layer is also P-type. If the type of the doping element of the substrate is N-type, the type of the doping element in the doped conductive layer is also N-type.

The material of the anti-reflection layer may be one of silicon oxide, aluminum oxide, silicon nitride or silicon oxynitride.

In some embodiments, the orthogonal projection of the at least one first overlapping grid line 211 on the first surface 201 overlaps with the orthogonal projection of the at least one second overlapping grid line 221 on the first surface 201, which means that the at least one first overlapping grid line 211 and the at least one second overlapping grid line 221 have an overlapping area in the direction perpendicular to the first surface 201. For example, referring to FIG. 8, the orthographic projection of some of the at least one first overlapping grid line 211 on the first surface 201 may completely overlap with the orthographic projection of some of the at least one second overlapping grid line 221 on the first surface 201; or, the orthogonal projection of some of the at least one first overlapping grid line 211 on the first surface 201 may only partially overlap with the orthogonal projection of some of the at least one second overlapping grid line 221 on the first surface 201; or, the boundary of the orthogonal projection of some of the at least one first overlapping grid line 211 on the first surface 201 overlaps with the boundary of the orthogonal projection of some of the at least one second overlapping grid line 221 on the first surface 201.

It should be noted that in FIG. 8, taking the example that a width of a single first grid line 210 is equal to a width of a single second grid line 220 in the direction perpendicular to the extending direction of the first grid line 210, the dimensional relationship between the first grid line 210 and the second grid line 220 is not limited. In some embodiments, the width of a single first grid line may not be equal to the width of a single second grid line in the direction perpendicular to the extending direction of the first grid line 210. In this way, the orthographic projection of a single first overlapping grid line on the first surface completely overlapping with the orthographic projection of a single second overlapping grid line on the first surface, means that the orthographic projection of the single first overlapping grid line on the first surface is within the orthographic projection of the single second overlapping grid line on the first surface, or, the orthographic projection of the single second overlapping grid line on the first surface is located in the orthographic projection of the single first overlapping grid line on the first surface.

In some embodiments, the materials of the first grid lines 210 and the material of the second grid lines 220 may include at least one of silver, aluminum, copper, tin, gold, lead or nickel.

At S72, a first laser sintering process is performed on the at least one first overlapping grid line 211. The first laser sintering process includes: performing the first laser processing on the first surface 201 on two sides of each of the at least one first overlapping grid line 211 and applying a first reverse current between the at least one first overlapping grid line 211 and the at least one second overlapping grid line 221. A ratio of laser power of the first laser processing to breakdown power ranges from 0.9 to 1, such as 0.9, 0.92, 0.93, 0.95, 0.97, 0.98 or 1. A ratio of the first reverse current to a breakdown current is, for example, 0.75, 0.77, 0.79, 0.8, 0.82, 0.84, 0.86, 0.88, 0.9, 0.91, 0.94, 0.97 or 1. The breakdown power and the breakdown current are laser power and reverse current corresponding to breaking down a PN junction between the at least one first overlapping grid line 211 and the at least one second overlapping grid line 221 during performing the laser processing on the at least one first overlapping grid line 211.

In some embodiments, the breakdown power and the breakdown current are obtained by testing a test cell sheet. For example, a front surface and a back surface of the test cell sheet include front overlapping grid lines and back overlapping grid lines respectively, and orthogonal projections of the front overlapping grid lines on the front surface completely overlap with orthogonal projections of the back overlapping grid lines on the front surface. The manufacturing process of the test cell sheet is the same as the manufacturing process of the cell sheet. By performing laser processing on two sides of the front overlapping grid lines of the test cell sheet, and applying a reverse current between the first overlapping grid lines and the second overlapping grid lines, a PN junction between the first overlapping grid lines and the second overlapping grid lines is broken down. The laser power and the reverse current corresponding to breaking down the PN junction are obtained as the breakdown power and the breakdown current.

It should be understood that when the ratio of the laser power of the first laser processing to the breakdown power is 1, the ratio of the first reverse current to the breakdown current is less than 1, so as to avoid the breakdown of the PN junction between the first overlapping grid lines 211 and the second overlapping grid lines 221. When the ratio of the first reverse current to the breakdown current is 1, the ratio of the laser power of the first laser processing to the breakdown power is less than 1, so as to avoid the breakdown of the PN junction between the first overlapping grid lines 211 and the second overlapping grid lines 221.

In the method for preparing the solar cell provided by this embodiment of the present disclosure, the laser processing is performed on the first surface 201 on the two sides of each of the at least one first overlapping grid line 211 on the cell sheet 200, and the reverse current is applied between the at least one first overlapping grid line 211 and the at least one second overlapping grid line 212. Under the irradiation of laser, a large number of carriers are generated in the region on two sides of each of the at least one first overlapping grid line 211 in the cell sheet 200. At the same time, due to the reverse current, the electrons in the carriers can be trapped on the surface of the cell sheet 200 in contact with the at least one first overlapping grid line 211. The electrons react with the at least one first overlapping grid line 211, causing the metal ions in the at least one first overlapping grid line 211 to precipitate metal micelles. The metal micelles form conductive contact points between the at least one first overlapping grid line 211 and the semiconductor material inside the cell sheet 200, which can reduce the contact resistance between the at least one first overlapping grid line 211 and the semiconductor material, and is beneficial to improving the filling factor of the solar cell, thereby enhancing the photoelectric conversion efficiency of the solar cell. In addition, due to the short distance between the at least one first overlapping grid line 211 and the at least one second overlapping grid line 221, the PN junction between the at least one first overlapping grid line 211 and the at least one second overlapping grid line 221 is easily broken down during the first laser processing. By setting the ratio of the laser power of the first laser processing to the breakdown power to range from 0.9 to 1, and the ratio of the first reverse current to the breakdown current to range from 0.75 to 1, the problem that the PN junction between the at least one first overlapping grid line 211 and the at least one second overlapping grid line 221 is broken down can be avoided, and the at least one first overlapping grid line 211 has a good sintering degree, so as to avoid the problem that the efficiency of the solar cell is reduced due to excessive sintering or low sintering degree.

FIG. 9 is a schematic structural diagram of a cell sheet according to an embodiment.

Referring to FIG. 9, in some embodiments, the number of the first grid lines 210 and the number of the second grid lines 220 may be equal. In this way, all the first grid lines 210 on the first surface 201 of the cell sheet 200 may be first overlapping grid lines 211, and all the corresponding second grid lines 220 on the second surface 202 of the cell sheet 200 may be second overlapping grid lines 221. That is, in the direction perpendicular to the first surface 201, all the first grid lines 210 and all the second grid lines 220 have overlapping regions. In this way, only the first laser processing may be performed to sinter the first grid lines 210.

It should be noted that in FIG. 9, a size of the first grid line 210 is the same as a size of the second grid line 220, and the first overlapping grid lines 211 and the second overlapping grid lines 221 completely overlap. In some embodiments, the first overlapping grid lines and the second overlapping grid lines may partially overlap. For example, the number of the first grid lines on the first surface may be 148, and the spacing between any two first grid lines may range from 1.1 mm to 1.5 mm, such as 1.1 mm, 1.12 mm, 1.33 mm, 1.45 mm or 1.5 mm. The number of second grid lines on the second surface may be 148, and the spacing between the second grid lines may range from 1.1 mm to 1.5 mm, for example, 1.1 mm, 1.12 mm, 1.33 mm, 1.45 mm or 1.5 mm, as long as there is an overlapping region between the first overlapping grid line and the second overlapping grid line.

In some embodiments, the number of the first grid lines 210 and the number of the second grid lines 220 may be unequal. For example, referring to FIG. 8, at least one first grid line 210 is a first non-overlapping grid line 212 and at least one second grid line 220 is a second non-overlapping grid line 222, and an orthographic projection of the first non-overlapping grid line 212 on the first surface 201 does not overlap with an orthographic projection of the second non-overlapping grid line 222 on the first surface 201. That is, in the direction perpendicular to the first surface 201, the first non-overlapping grid line 212 and the second non-overlapping grid line 222 have no overlapping region. In this way, after the first laser processing is performed on the first overlapping grid line 211, the method may further include: performing a second laser sintering process on the first non-overlapping grid line 212. The second laser sintering process includes: performing a second laser processing on the first surface 201 on two sides of the first non-overlapping grid line 212, and applying a second reverse current between the first non-overlapping grid line 212 and the second non-overlapping grid line 222. Laser power of the second laser processing is greater than the breakdown power, and the second reverse current is greater than the breakdown current.

It should be understood that a distance between the first non-overlapping grid line 212 and the second non-overlapping grid line 222 is farther than a distance between the first overlapping grid line 211 and the second overlapping grid line 221, so that the problem of breakdown of the PN junction between the first non-overlapping grid line 212 and the second non-overlapping grid line 222 is less likely to occur during the second laser processing. Furthermore, during the second laser processing, a laser power greater than the breakdown power and a second reverse current greater than the breakdown current can be used, so that the first non-overlapping grid line 212 can have a better sintering degree, thereby improving the filling factor of the solar cell and the photoelectric conversion efficiency of the solar cell.

FIG. 10 is a schematic structural diagram of another cell sheet according to an embodiment of the present disclosure.

Referring to FIG. 10, the number of the first grid lines 210 may be twice the number of the second grid lines 220, so that the first overlapping grid lines 211 and the first non-overlapping grid lines 212 on the first surface 201 may be alternatingly arranged, and the second surface 220 may only have the second overlapping grid lines 221.

It should be noted that in FIG. 10, the size of the first grid line 210 is the same as the size of the second grid line 220, and the first overlapping grid lines 211 and the second overlapping grid lines 221 completely overlap. In some embodiments, the first overlapping grid lines and the second overlapping grid lines may partially overlap. For example, when the number of first grid lines on the first surface is 320, the spacing between any two first grid lines may range from 1.1 mm to 1.5 mm, such as 1.1 mm, 1.12 mm, 1.33 mm, 1.45 mm or 1.5 mm. The number of second grid lines on the second surface may be 160, and the spacing between any two second grid lines may twice to triple, such as 2, 2.3, 2.5, 2.8 or 3, of the spacing between any two first grid lines, as long as there is an overlapping region between the first overlapping grid lines and the second overlapping grid lines, and the regions corresponding to the first non-overlapping grid lines do not have any second grid line.

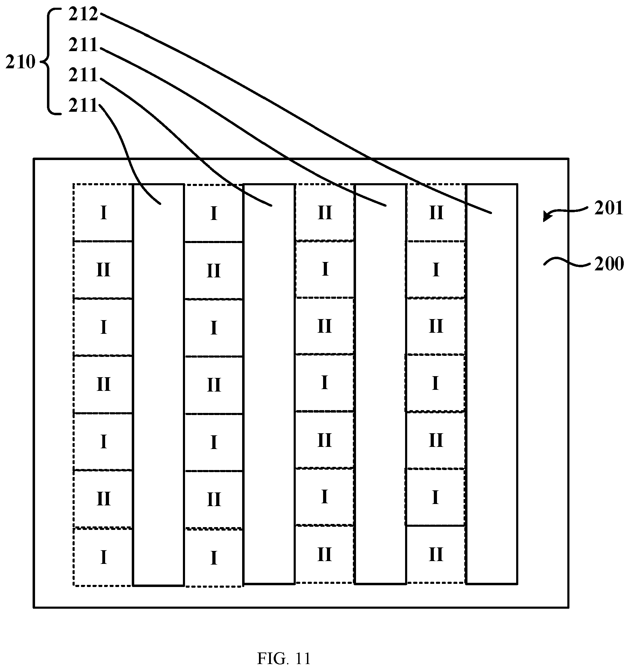

FIG. 11 is a top view of a cell sheet according to an embodiment of the present disclosure. FIG. 11 takes the top view corresponding to the cell sheet shown in FIG. 8 as an example, and does not limit the structure of the cell sheet.

In some embodiments, the first surface 201 on two sides of each of the at least one first overlapping grid line 211 include laser processing regions I and non-laser processing regions II which are alternatingly arranged in an extending direction of the at least one first overlapping grid line 211. Performing the first laser processing on the first surface 201 on two sides of the at least one first overlapping grid line 211 includes: performing the first laser processing only on the laser processing regions I on the two sides of the at least one first overlapping grid line 211.

That is, during the first laser sintering process, the first surface 201 on two sides of each of the at least one first overlapping grid line 211 is subjected to intermittent laser processing by combining virtual and real irradiation, and the laser processing regions I are irradiated, while the non-laser processing regions II are not irradiated, so that a large number of carriers are generated in the laser processing regions I, and no carriers is generated in the non-laser processing regions II or less carriers is generated due to the radiation of the laser processing regions I. In this way, the number of generated carriers can be precisely controlled by the irradiation mode of patterning the first laser irradiation regions I, thereby being beneficial to controlling the sintering degree of the first grid lines 211.

In FIG. 11, for example, in a direction perpendicular to the extending direction of the first overlapping grid line 211, a width of a single laser region I is equal to the spacing between any two adjacent first grid lines 211, so that the two adjacent first grid lines 211 jointly use the generated carriers in the same laser processing region I during the first laser processing. In some embodiments, in the direction perpendicular to the extending direction of the first overlapping grid line, the width of a single laser region can be less than or equal to half of the spacing between any two adjacent first overlapping grid lines, so that the first overlapping grid lines can have their own respective laser regions.

In some embodiments, in the direction perpendicular to the extending direction of the first overlapping grid line 211, the laser regions I on two sides of the first overlapping grid line 211 may be symmetrically or asymmetrically arranged along the first overlapping grid line 211. That is, for any first overlapping grid line 211, the arrangement of the laser regions I and the non-laser regions II on one side of the first overlapping grid line 211 may be the same as or different from that on the other side of the first overlapping grid line 211.

In some embodiments, in the extending direction of the first overlapping grid line 211, a ratio of a total length of the non-laser processing regions II to a total length of the laser processing regions I ranges from 2:1 to 4:1, such as 2:1, 2.3:1, 3:1, 3.6:1, or 4:1.

In some embodiments, in the extending direction of the first overlapping grid line 211, a length of a single laser processing region I ranges from 1 µm to 5 µm, such as 1 µm, 1.5 µm, 2 µm, 2.4 µm, 3 µm, 3.6 µm, 4 µm, 4.7 µm or 5 µm. A length of a single non-laser processing region II ranges from 3 µm to 7 µm, such as 3 µm, 3.3 µm, 4 µm, 4.6 µm, 5 µm, 5.9 µm, 6 µm, 6.5 µm or 7 µm.

In some embodiments, during performing a first laser processing on the first surface 201 on two sides of a respective first overlapping grid line 21 of the plurality of first overlapping grid lines 201, the method further includes: performing the first laser processing on the respective first overlapping grid line 211. It should be understood that when the size of the laser spot processed by the first laser is large, the laser processed by the first laser may also be irradiated on the first overlapping grid line 211. Due to the smaller size of the laser spot, the corresponding spot is prone to generate higher energy density, resulting in excessive damage to the surface of the material. When the size of the laser spot is large, the laser can be prevented from damaging to the first overlapping grid line 211, so that the laser processed by the first laser can be hit on the first overlapping grid line 211.

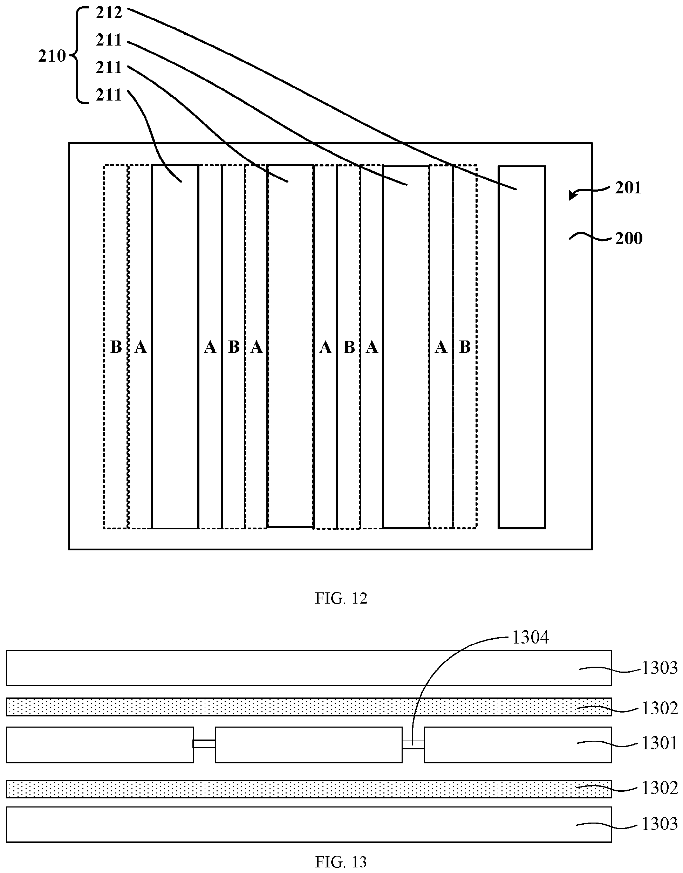

FIG. 12 is a top view of another cell sheet according to an embodiment of the present disclosure.

Referring to FIG. 12, in some embodiments, the first surface 201 includes a plurality of first laser regions A and a plurality of second laser regions B, two of the plurality of first laser regions A are located on two sides of the respective first overlapping grid line 201 in the direction perpendicular to the extending direction of the respective first overlapping grid line 211, and two of the plurality of second laser regions B are located on sides of the two first laser regions A away from the respective first overlapping grid line 211. Performing the first laser processing on the first surface 201 on two sides of the respective first overlapping grid line 211 of the plurality of first overlapping grid lines 211 includes: performing the first laser processing on the plurality of first laser regions A. After performing the first laser processing, the method further includes: performing a third laser sintering process on the first overlapping grid line 211. The third laser sintering process includes: performing the third laser processing on the plurality of second laser regions B, and applying a third reverse current between the first overlapping grid lines 211 and the second overlapping grid lines 212. Laser power of the third laser processing is greater than the laser power of the first laser processing, and the third reverse current is greater than the first reverse current.

That is, the laser sintering of the first overlapping grid line 211 is performed in two steps. The regions irradiated by the laser during the first laser processing are located on the two sides adjacent to the first overlapping grid line 211, and the regions irradiated by the laser during the third laser processing are located in the regions at intervals from the first overlapping grid line 211. In this way, the sintering degree of the first overlapping grid line 211 can be controlled more precisely, which is beneficial to adjusting the process conditions of the third laser processing according to the sintering degree of the first laser processing. Due to the interval between the first overlapping grid line 211 and the second laser regions, the carriers generated by the third laser processing reach below the first grid line 211 more slowly than the carriers generated by the first laser processing, and the corresponding laser power and the third reverse current of the third laser processing can be appropriately increased compared with the process conditions of the first laser processing.

In some embodiments, in the extending direction of the respective first overlapping grid line, each first laser region includes laser processing regions and non-laser processing regions which are alternatingly arranged. The performing the first laser processing on the plurality of first laser regions includes: performing the first laser processing only on the laser processing regions of the respective first laser region. The performing a third laser processing on the plurality of second laser regions includes: performing the third laser processing on all the second laser regions.

That is, in the process of performing laser processing on the first overlapping grid line by two-step laser sintering, the irradiation of the first laser processing can also adopt a combination of virtual and real irradiation, which is beneficial to precisely regulating the number of generated carriers, thereby being beneficial to controlling the sintering degree of the first overlapping grid line.

In some embodiments, in the direction perpendicular to the extending direction of the respective first overlapping grid line 211, a ratio of a width of a single first laser region A to a width of a single second laser region B may range from 0.6 to 1.6, such as 0.6, 0.8, 1, 1.1, 1.3, 1.5, or 1.6.

In some embodiments, in the direction perpendicular to the extending direction of the respective first overlapping grid line 211, the width of a single first laser region A ranges from 60 µm to 100 µm, such as 60 µm, 70 µm, 75 µm, 80 µm, 85 µm, 90 µm, 95 µm, or 100 µm. The width of a single second laser region B ranges from 60 µm and 100 µm, such as 60 µm, 70 µm, 75 µm, 80 µm, 85 µm, 90 µm, 95 µm, or 100 µm.

In FIG. 10, the same second laser region B is used to generate carriers during the second laser processing between two adjacent first overlapping grid lines 211. In some embodiments, the second laser regions corresponding to different first overlapping grid lines can be arranged at intervals from each other, so as to utilize the carriers generated by different second laser regions during the second laser processing.

According to some embodiments of the present disclosure, a solar cell is further provided according to another aspect of the embodiments of the present disclosure, which is prepared by any one of the methods for preparing the solar cell in the above embodiments, so as to improve the efficiency of the solar cell. It should be noted that the parts that are the same as or corresponding to the above-mentioned embodiments can refer to the corresponding descriptions of the above-mentioned embodiments, and will not be described in detail below.

In some embodiments, the solar cell may be one of a Passivated Emitter and Rear Cell (PERC), a Passivated Emitter and Rear Totally-diffused (PERT) Cell, a Tunnel Oxide Passivated Contact (TOPCON) Cell and a Heterojunction Technology (HIT/HJT) Cell.

In some embodiments, the solar cell can be a single-sided cell, so that the first surface 201 of the cell sheet 200 can be used as a light receiving surface for receiving incident light, and the second surface 202 can be used as a backlight surface. In some embodiments, the solar cell can also be a bifacial cell, so both the first surface 201 and the second surface 202 of the cell sheet 200 can be used as light receiving surfaces and can be configured to receive incident light.

According to some embodiments of the present disclosure, a photovoltaic module is further provided according to another aspect of the embodiments of the present disclosure, referring to FIG. 13, which includes at least one solar cell 1301 in the above embodiments. It should be noted that the parts that are the same as or corresponding to the above-mentioned embodiments can refer to the corresponding descriptions of the above-mentioned embodiments, and will not be described in detail below.

The photovoltaic module further includes a connecting component 1304, which is used for the interconnection between solar cells and collects current for transmitting the current to elements outside the photovoltaic module. In some embodiments, the connecting component includes a bus bar and an interconnection bar. The bus bar is configured to connect a photovoltaic cell string with a junction box, and the interconnection bar is configured to connect adjacent solar cells.

The photovoltaic module further includes at least one adhesive film 1302, which covers a surface of the solar cell. The film may be made of an organic packaging film such as an ethylene-vinyl acetate copolymer (EVA), a polyethylene octene copolymer (POE) or a polyvinyl butyral ester (PVB).

The photovoltaic module further includes at least one cover plate 1303, which covers a surface of the adhesive film away from the solar cell. The cover plate may be a glass cover plate, a plastic cover plate or other cover plates with light transmission function. Specifically, a surface of the cover plate facing the adhesive film may be an uneven(concave-convex) surface, thereby increasing the utilization rate of incident light.

According to some embodiments of the present disclosure, the following examples are provided.

According to some embodiments, a method for preparing a solar cell is provided. In the method, a cell sheet is provided. The cell sheet includes a first surface and a second surface opposite to each other, the first surface of the cell sheet has a plurality of first grid lines, the second surface of the cell sheet has a plurality of second grid lines, the plurality of first grid lines include at least one first overlapping grid line, the plurality of second grid lines include at least one second overlapping grid line, and an orthogonal projection of the at least one first overlapping grid line on the first surface overlaps with an orthogonal projection of the at least one second overlapping grid line on the first surface. The method further includes: performing a first laser sintering process on the at least one first overlapping grid line. The first laser sintering process includes: performing the first laser processing on the first surface on two sides of each of the at least one first overlapping grid line and applying a first reverse current between the at least one first overlapping grid line and the at least one second overlapping grid line. A ratio of laser power of the first laser processing to breakdown power ranges from 0.9 to 1, and a ratio of the first reverse current to a breakdown current ranges from 0.75 to 1. The breakdown power and the breakdown current are laser power and reverse current corresponding to breaking down a PN junction between the at least one first overlapping grid line and the at least one second overlapping grid line during performing the laser processing on the at least one first overlapping grid line.

In some embodiments, the plurality of first grid lines include at least one first non-overlapping grid line, the plurality of second grid lines include at least one second non-overlapping grid line, and an orthographic projection of the at least one first non-overlapping grid line on the first surface does not overlap with an orthographic projection of the at least one second non-overlapping grid line on the first surface. After performing the first laser processing on the at least one first overlapping grid line, the method further includes: performing a second laser sintering process on the at least one first non-overlapping grid line. The second laser sintering process includes: performing the second laser processing on the first surface 201 on two sides of each of the at least one first non-overlapping grid line, and applying a second reverse current between the at least one first non-overlapping grid line and the at least one second non-overlapping grid line. Laser power of the second laser processing is greater than the breakdown power, and the second reverse current is greater than the breakdown current.

In some embodiments, the first surface on two sides of each of the at least one first overlapping grid line include laser processing regions and non-laser processing regions, and the laser processing regions and the non-laser processing regions are alternatingly arranged in an extending direction of the at least one first overlapping grid line. Performing the first laser processing on the first surface on two sides of each of the at least one first overlapping grid line includes: performing the first laser processing only on the laser processing regions on the two sides of each of the at least one first overlapping grid line.

In some embodiments, in the extending direction of the at least one first overlapping grid line, a ratio of a total length of the non-laser processing regions to a total length of the laser processing regions ranges from 2:1 to 4:1.

In some embodiments, in the extending direction of the at least one first overlapping grid line, a length of each laser processing region ranges from 1 µm to 5 µm, and a length of each non-laser processing region II ranges from 3 µm to 7 µm.

In some embodiments, during performing the first laser processing on the first surface on two sides of each respective first overlapping grid line of the at least one first overlapping grid line, the method further includes: performing the first laser processing on the respective first overlapping grid line.

In some embodiments, the first surface includes a plurality of first laser regions and a plurality of second laser regions, two of the plurality of first laser regions are located on two sides of the respective first overlapping grid line in the direction perpendicular to the extending direction of the respective first overlapping grid line, and two of the plurality of second laser regions are located on sides of the two first laser regions away from the respective first overlapping grid line. Performing the first laser processing on the first surface on two sides of the respective first overlapping grid line of the at least one first overlapping grid line includes: performing the first laser processing on the plurality of first laser regions. After performing the first laser processing, the method further includes: performing a third laser sintering process on the at least one first overlapping grid line. The third laser sintering process includes: performing the third laser processing on the plurality of second laser regions, and applying a third reverse current between the at least one first overlapping grid line and the at least one second overlapping grid line. Laser power of the third laser processing is greater than the laser power of the first laser processing, and the third reverse current is greater than the first reverse current.

In some embodiments, a respective first laser region of the plurality of first laser regions includes laser processing regions and non-laser processing regions which are alternatingly arranged in the extending direction of the respective first overlapping grid line. Performing the first laser processing on the plurality of first laser regions includes: performing the first laser processing only on the laser processing regions of the respective first laser region. Performing the third laser processing on the plurality of second laser regions includes: performing the third laser processing on all the second laser regions.

In some embodiments, in the direction perpendicular to the extending direction of the respective first overlapping grid line, a ratio of a width of a single first laser region to a width of a single second laser region ranges from 0.6 to 1.6.

In some embodiments, in the direction perpendicular to the extending direction of the respective first grid line, the width of a single first laser region ranges from 60 µm to 100 µm, and the width of a single second laser region ranges from 60 µm and 100 µm.

According to some embodiments of the present disclosure, a solar cell is provided, and is prepared by the method for preparing the solar cell according to any one of the above.

According to some embodiments of the present disclosure, a photovoltaic module is provided, which includes at least one solar cell according to any one of the above, at least one adhesive film, covering a surface of the at least one solar cell; and at least one cover plate, covering a surface of the at least one adhesive film away from the at least one solar cell.

It can be understood by those skilled in the art that the above-mentioned embodiments are concrete embodiments for realizing the present disclosure, but in practical application, various changes can be made in form and details without departing from the scope of the present disclosure.

## Claims

1. A method for preparing a solar cell, comprising:
providing a cell sheet (200), wherein the cell sheet (200) includes a first surface (201) and a second surface (202) opposite to each other, a plurality of first grid lines (211) arranged on the first surface, and a plurality of second grid lines (212) arranged on the second surface, and orthogonal projections of the plurality of first grid lines (211) on the first surface do not overlap with orthogonal projections of the plurality of second grid lines (212) on the first surface;
performing a first laser processing on the first surface on two sides of a respective first grid line of the plurality of first grid lines (211), and applying a first reverse current between the plurality of first grid lines (211) and the plurality of second grid lines (212), wherein a ratio of laser power of the first laser processing to preset power ranges from 1 to 1.1, and a ratio of the first reverse current to a preset current ranges from 1 to 1.25, and the preset power and the preset current are respectively a laser power and a reverse current corresponding to breaking down PN junctions between the plurality of first grid lines (211) and the plurality of second grid lines (212) during performing laser processing on the plurality of first grid lines (211) in a test case that the orthogonal projections of the plurality of first grid lines on the first surface overlap with the orthogonal projections of the plurality of second grid lines (212) on the first surface.

2. The method for preparing the solar cell according to claim 1, wherein the first surface on two sides of the respective first grid line includes laser processing regions (I) and non-laser processing regions (II), which are alternatingly arranged in an extending direction of the respective first grid line;
performing the first laser processing on the first surface on two sides of the respective first grid line of the plurality of first grid lines (211) includes: performing the first laser processing only on the laser processing regions (I) on the two sides of the respective first grid line.

3. The method for preparing the solar cell according to claim 2, wherein in the extending direction of the respective first grid line, a ratio of a total length of the laser processing regions (I) to a total length of the non-laser processing regions (II) ranges from 2:1 to 4:1.

4. The method for preparing the solar cell according to claim 2 or claim 3, wherein in the extending direction of the respective first grid line, a length of a single laser processing region of the laser processing regions (I) ranges from 1 µm to 5 µm, and a length of a single non-laser processing region of the non-laser processing regions (II) ranges from 3 µm to 7 µm.

5. The method for preparing the solar cell according to any one of claims 1 to 4, wherein during performing the first laser processing on the first surface on two sides of the respective first grid line of the plurality of first grid lines, the method further includes: performing the first laser processing on the respective first grid line.

6. The method for preparing the solar cell according to any one of claims 1 to 5, wherein the first surface includes a plurality of first laser regions and a plurality of second laser regions, wherein two of the plurality of first laser regions are located on the two sides of the respective first grid line in a direction perpendicular to an extending direction of the respective first grid line, two of the plurality of second laser regions are located on sides of the two first laser regions away from the respective first grid line, and an orthogonal projection of a respective second grid line of the plurality of second grid lines (212) on the first surface is located in a respective second laser region of the plurality of second laser regions;
performing the first laser processing on the first surface on two sides of the respective first grid line of the plurality of first grid lines (211) includes: performing the first laser processing on the plurality of first laser regions; and
after performing the first laser processing, the method further includes: performing a second laser processing on the plurality of second laser regions, and applying a second reverse current between the plurality of first grid lines (211) and the plurality of second grid lines (212), wherein laser power of the second laser processing is greater than laser power of the first laser processing, and the second reverse current is greater than the first reverse current.

7. The method for preparing the solar cell according to claim 6, wherein a respective first laser region of the two first laser regions includes laser processing regions and non-laser processing regions (II), which are alternatingly arranged in the extending direction of the respective first grid line;
performing the first laser processing on the plurality of first laser regions includes: performing the first laser processing only on the laser processing regions of the respective first laser region;
performing the second laser processing on the plurality of second laser regions includes: performing the second laser processing on all the second laser regions.

8. The method for preparing the solar cell according to claim 6, wherein in the direction perpendicular to the extending direction of the respective first grid line, a width of a single second laser region of the respective second laser regions is equal to a width of the respective second grid line; or
wherein in the direction perpendicular to the respective first grid line, widths of the two first laser regions on two sides of the respective second laser regions are equal;
optionally, wherein in the direction perpendicular to the extending direction of the respective first grid line, a ratio of a width of a respective first laser region of the two first laser regions to a width of the respective second laser region ranges from 0.6 to 1.6;
optionally, wherein in the direction perpendicular to the extending direction of the respective first grid line, the width of the respective first laser region ranges from 60 µm to 100 µm.

9. The method for preparing the solar cell according to any one of claims 1 to 8, wherein the preset power and the preset current are obtained by testing a test cell sheet;
the test cell sheet includes a front surface and a back surface opposite to each other, front grid lines arranged on the front surface, and back grid lines arranged on the back surface, wherein orthogonal projections of the front grid lines on the front surface completely overlap with orthogonal projections of the back grid lines on the front surface;
performing laser processing on a surface on two sides of each of the front grid lines of the test cell sheet, and applying a reverse current between the front grid lines and the back grid lines, to break down PN junctions between the front grid lines and the back grid lines, wherein laser power and the reverse current corresponding to breaking down the PN junctions are obtained as the preset power and the preset current.

10. The method for preparing the solar cell according to any one of claims 1 to 9, wherein the ratio of the laser power of the first laser processing to the preset power is 1, and the ratio of the first reverse current to the preset current is greater than 1; or
the ratio of the first reverse current to the preset current is 1, and the ratio of the laser power of the first laser processing to the preset power is greater than 1.

11. The method for preparing the solar cell according to claim 1, wherein distances of an orthogonal projection of any respective second grid line of the plurality of second grid lines (212) on the first surface to orthogonal projections of two adjacent first grid lines (211) on the first surface are equal.

12. The method for preparing the solar cell according to claim 1, wherein a number of the plurality of second grid lines (212) is twice of a number of the plurality of first grid lines, and any respective first grid line of the plurality of first grid lines is arranged at a corresponding position in the middle of two adjacent second grid lines of the plurality of second grid lines (212) at intervals from the two adjacent second grid lines; or
wherein a number of the plurality of second grid lines (212) is equal to a number of the plurality of first grid lines (211), and any respective first grid line of the plurality of first grid lines (211) is located in a region between two adjacent second grid lines of the plurality of second grid lines (212).

13. The method for preparing the solar cell according to claim 2, wherein in a direction perpendicular to the extending direction of the respective first grid line, a width of a single laser processing region of the laser processing regions is equal to a spacing between any two adjacent first grid lines of the plurality of first grid lines (211); or
wherein in a direction perpendicular to the extending direction of the respective first grid line, a width of a single laser processing region of the laser processing regions is less than or equal to half of a spacing between any two adjacent first grid lines of the plurality of first grid lines (211).

## Patentansprüche

1. Verfahren zur Herstellung einer Solarzelle, umfassend:
das Bereitstellen eines Zellblatts (200), wobei das Zellblatt (200) eine erste Oberfläche (201) und eine zweite Oberfläche (202), die einander gegenüberliegen, eine Vielzahl von ersten Gitterleitungen (211), die auf der ersten Oberfläche angeordnet sind, und eine Vielzahl von zweiten Gitterleitungen (212), die auf der zweiten Oberfläche angeordnet sind, umfasst, und orthogonale Projektionen der Vielzahl von ersten Gitterleitungen (211) auf die erste Oberfläche nicht mit orthogonalen Projektionen der Vielzahl von zweiten Gitterleitungen (212) auf die erste Oberfläche überlappen;
das Durchführen einer ersten Laserbearbeitung auf der ersten Oberfläche auf zwei Seiten einer jeweiligen ersten Gitterleitung der Vielzahl von ersten Gitterleitungen (211), und das Anlegen eines ersten Rückstroms zwischen der Vielzahl von ersten Gitterleitungen (211) und der Vielzahl von zweiten Gitterleitungen (212), wobei ein Verhältnis einer Laserleistung der ersten Laserbearbeitung zu einer voreingestellten Leistung von 1 bis 1,1 reicht, und ein Verhältnis des ersten Rückstroms zu einem voreingestellten Strom von 1 bis 1,25 reicht, und die voreingestellte Leistung und der voreingestellte Strom jeweils eine Laserleistung und ein Rückstrom sind, die dem Durchbrechen von PN-Übergängen zwischen der Vielzahl von ersten Gitterleitungen (211) und der Vielzahl von zweiten Gitterleitungen (212) während der Durchführung einer Laserbearbeitung auf der Vielzahl von ersten Gitterleitungen (211) in einem Testfall entsprechen, in dem die orthogonalen Projektionen der Vielzahl von ersten Gitterleitungen auf die erste Oberfläche mit den orthogonalen Projektionen der Vielzahl von zweiten Gitterleitungen (212) auf die erste Oberfläche überlappen.

2. Verfahren zur Herstellung der Solarzelle nach Anspruch 1, wobei die erste Oberfläche auf zwei Seiten der jeweiligen ersten Gitterleitung Laserbearbeitungsbereiche (I) und Nicht-Laserbearbeitungsbereiche (II) umfasst, die abwechselnd in einer Erstreckungsrichtung der jeweiligen ersten Gitterleitung angeordnet sind;
das Durchführen der ersten Laserbearbeitung auf der ersten Oberfläche auf zwei Seiten der jeweiligen ersten Gitterleitung der Vielzahl von ersten Gitterleitungen (211) umfasst: das Durchführen der ersten Laserbearbeitung nur auf den Laserbearbeitungsbereichen (I) auf den zwei Seiten der jeweiligen ersten Gitterleitung.

3. Verfahren zur Herstellung der Solarzelle nach Anspruch 2, wobei in der Erstreckungsrichtung der jeweiligen ersten Gitterleitung ein Verhältnis einer Gesamtlänge der Laserbearbeitungsbereiche (I) zu einer Gesamtlänge der Nicht-Laserbearbeitungsbereiche (II) von 2:1 bis 4:1 reicht.

4. Verfahren zur Herstellung der Solarzelle nach Anspruch 2 oder Anspruch 3, wobei in der Erstreckungsrichtung der jeweiligen ersten Gitterleitung eine Länge eines einzelnen Laserbearbeitungsbereichs der Laserbearbeitungsbereiche (I) von 1 µm bis 5 µm reicht, und eine Länge eines einzelnen Nicht-Laserbearbeitungsbereichs der Nicht-Laserbearbeitungsbereiche (II) von 3 µm bis 7 µm reicht.

5. Verfahren zur Herstellung der Solarzelle nach einem der Ansprüche 1 bis 4, wobei während der Durchführung der ersten Laserbearbeitung auf der ersten Oberfläche auf zwei Seiten der jeweiligen ersten Gitterleitung der Vielzahl von ersten Gitterleitungen das Verfahren ferner umfasst: das Durchführen der ersten Laserbearbeitung auf der jeweiligen ersten Gitterleitung.

6. Verfahren zur Herstellung der Solarzelle nach einem der Ansprüche 1 bis 5, wobei die erste Oberfläche eine Vielzahl von ersten Laserbereichen und eine Vielzahl von zweiten Laserbereichen umfasst, wobei zwei der Vielzahl von ersten Laserbereichen auf den zwei Seiten der jeweiligen ersten Gitterleitung in einer Richtung senkrecht zu einer Erstreckungsrichtung der jeweiligen ersten Gitterleitung angeordnet sind, zwei der Vielzahl von zweiten Laserbereichen auf Seiten der zwei ersten Laserbereiche entfernt von der jeweiligen ersten Gitterleitung angeordnet sind, und eine orthogonale Projektion einer jeweiligen zweiten Gitterleitung der Vielzahl von zweiten Gitterleitungen (212) auf die erste Oberfläche in einem jeweiligen zweiten Laserbereich der Vielzahl von zweiten Laserbereichen angeordnet ist;
das Durchführen der ersten Laserbearbeitung auf der ersten Oberfläche auf zwei Seiten der jeweiligen ersten Gitterleitung der Vielzahl von ersten Gitterleitungen (211) umfasst: das Durchführen der ersten Laserbearbeitung auf der Vielzahl von ersten Laserbereichen; und
nach dem Durchführen der ersten Laserbearbeitung umfasst das Verfahren ferner: das Durchführen einer zweiten Laserbearbeitung auf der Vielzahl von zweiten Laserbereichen, und das Anlegen eines zweiten Rückstroms zwischen der Vielzahl von ersten Gitterleitungen (211) und der Vielzahl von zweiten Gitterleitungen (212), wobei eine Laserleistung der zweiten Laserbearbeitung größer ist als eine Laserleistung der ersten Laserbearbeitung, und der zweite Rückstrom größer ist als der erste Rückstrom.

7. Verfahren zur Herstellung der Solarzelle nach Anspruch 6, wobei ein jeweiliger erster Laserbereich der zwei ersten Laserbereiche Laserbearbeitungsbereiche und Nicht-Laserbearbeitungsbereiche (II) umfasst, die abwechselnd in der Erstreckungsrichtung der jeweiligen ersten Gitterleitung angeordnet sind;
das Durchführen der ersten Laserbearbeitung auf der Vielzahl von ersten Laserbereichen umfasst: das Durchführen der ersten Laserbearbeitung nur auf den Laserbearbeitungsbereichen des jeweiligen ersten Laserbereichs;
das Durchführen der zweiten Laserbearbeitung auf der Vielzahl von zweiten Laserbereichen umfasst: das Durchführen der zweiten Laserbearbeitung auf allen zweiten Laserbereichen.

8. Verfahren zur Herstellung der Solarzelle nach Anspruch 6, wobei in der Richtung senkrecht zur Erstreckungsrichtung der jeweiligen ersten Gitterleitung eine Breite eines einzelnen zweiten Laserbereichs der jeweiligen zweiten Laserbereiche gleich einer Breite der jeweiligen zweiten Gitterleitung ist; oder
wobei in der Richtung senkrecht zur jeweiligen ersten Gitterleitung Breiten der zwei ersten Laserbereiche auf zwei Seiten der jeweiligen zweiten Laserbereiche gleich sind;
optional, wobei in der Richtung senkrecht zur Erstreckungsrichtung der jeweiligen ersten Gitterleitung ein Verhältnis einer Breite eines jeweiligen ersten Laserbereichs der zwei ersten Laserbereiche zu einer Breite des jeweiligen zweiten Laserbereichs von 0,6 bis 1,6 reicht;
optional, wobei in der Richtung senkrecht zur Erstreckungsrichtung der jeweiligen ersten Gitterleitung die Breite des jeweiligen ersten Laserbereichs von 60 µm bis 100 µm reicht.

9. Verfahren zur Herstellung der Solarzelle nach einem der Ansprüche 1 bis 8, wobei die voreingestellte Leistung und der voreingestellte Strom durch Testen eines Testzellblatts erhalten werden;
das Testzellblatt eine Vorderseite und eine Rückseite, die einander gegenüberliegen, Vordergitterleitungen, die auf der Vorderseite angeordnet sind, und Rückgitterleitungen, die auf der Rückseite angeordnet sind, umfasst, wobei orthogonale Projektionen der Vordergitterleitungen auf die Vorderseite vollständig mit orthogonalen Projektionen der Rückgitterleitungen auf die Vorderseite überlappen;
das Durchführen einer Laserbearbeitung auf einer Oberfläche auf zwei Seiten jeder der Vordergitterleitungen des Testzellblatts, und das Anlegen eines Rückstroms zwischen den Vordergitterleitungen und den Rückgitterleitungen, um PN-Übergänge zwischen den Vordergitterleitungen und den Rückgitterleitungen zu durchbrechen, wobei eine Laserleistung und der Rückstrom, die dem Durchbrechen der PN-Übergänge entsprechen, als die voreingestellte Leistung und der voreingestellte Strom erhalten werden.

10. Verfahren zur Herstellung der Solarzelle nach einem der Ansprüche 1 bis 9, wobei das Verhältnis der Laserleistung der ersten Laserbearbeitung zu der voreingestellten Leistung 1 beträgt, und das Verhältnis des ersten Rückstroms zu dem voreingestellten Strom größer als 1 ist; oder
das Verhältnis des ersten Rückstroms zu dem voreingestellten Strom 1 beträgt, und das Verhältnis der Laserleistung der ersten Laserbearbeitung zu der voreingestellten Leistung größer als 1 ist.

11. Verfahren zur Herstellung der Solarzelle nach Anspruch 1, wobei Abstände einer orthogonalen Projektion einer beliebigen jeweiligen zweiten Gitterleitung der Vielzahl von zweiten Gitterleitungen (212) auf die erste Oberfläche zu orthogonalen Projektionen von zwei benachbarten ersten Gitterleitungen (211) auf die erste Oberfläche gleich sind.

12. Verfahren zur Herstellung der Solarzelle nach Anspruch 1, wobei eine Anzahl der Vielzahl von zweiten Gitterleitungen (212) das Doppelte einer Anzahl der Vielzahl von ersten Gitterleitungen beträgt, und jede jeweilige erste Gitterleitung der Vielzahl von ersten Gitterleitungen an einer entsprechenden Position in der Mitte von zwei benachbarten zweiten Gitterleitungen der Vielzahl von zweiten Gitterleitungen (212) in Abständen von den zwei benachbarten zweiten Gitterleitungen angeordnet ist; oder
wobei eine Anzahl der Vielzahl von zweiten Gitterleitungen (212) gleich einer Anzahl der Vielzahl von ersten Gitterleitungen (211) ist, und jede jeweilige erste Gitterleitung der Vielzahl von ersten Gitterleitungen (211) in einem Bereich zwischen zwei benachbarten zweiten Gitterleitungen der Vielzahl von zweiten Gitterleitungen (212) angeordnet ist.

13. Verfahren zur Herstellung der Solarzelle nach Anspruch 2, wobei in einer Richtung senkrecht zur Erstreckungsrichtung der jeweiligen ersten Gitterleitung eine Breite eines einzelnen Laserbearbeitungsbereichs der Laserbearbeitungsbereiche gleich einem Abstand zwischen zwei beliebigen benachbarten ersten Gitterleitungen der Vielzahl von ersten Gitterleitungen (211) ist; oder
wobei in einer Richtung senkrecht zur Erstreckungsrichtung der jeweiligen ersten Gitterleitung eine Breite eines einzelnen Laserbearbeitungsbereichs der Laserbearbeitungsbereiche kleiner oder gleich der Hälfte eines Abstands zwischen zwei beliebigen benachbarten ersten Gitterleitungen der Vielzahl von ersten Gitterleitungen (211) ist.

## Revendications

1. Procédé de préparation d'une cellule solaire, comprenant :
la fourniture d'une feuille de cellule (200), dans lequel la feuille de cellule (200) comprend une première surface (201) et une seconde surface (202) opposées l'une à l'autre, une pluralité de premières lignes de grille (211) agencées sur la première surface, et une pluralité de secondes lignes de grille (212) agencées sur la seconde surface, et des projections orthogonales de la pluralité de premières lignes de grille (211) sur la première surface ne chevauchent pas des projections orthogonales de la pluralité de secondes lignes de grille (212) sur la première surface ;
la réalisation d'un premier traitement laser sur la première surface sur deux côtés d'une première ligne de grille respective de la pluralité de premières lignes de grille (211), et l'application d'un premier courant inverse entre la pluralité de premières lignes de grille (211) et la pluralité de secondes lignes de grille (212), dans lequel un rapport d'une puissance laser du premier traitement laser à une puissance prédéfinie va de 1 à 1,1, et un rapport du premier courant inverse à un courant prédéfini va de 1 à 1,25, et la puissance prédéfinie et le courant prédéfini sont respectivement une puissance laser et un courant inverse correspondant au claquage de jonctions PN entre la pluralité de premières lignes de grille (211) et la pluralité de secondes lignes de grille (212) lors de la réalisation d'un traitement laser sur la pluralité de premières lignes de grille (211) dans un cas de test dans lequel les projections orthogonales de la pluralité de premières lignes de grille sur la première surface chevauchent les projections orthogonales de la pluralité de secondes lignes de grille (212) sur la première surface.

2. Procédé de préparation de la cellule solaire selon la revendication 1, dans lequel la première surface sur deux côtés de la première ligne de grille respective comprend des régions de traitement laser (I) et des régions de non-traitement laser (II), qui sont agencées en alternance dans une direction d'extension de la première ligne de grille respective ;
la réalisation du premier traitement laser sur la première surface sur deux côtés de la première ligne de grille respective de la pluralité de premières lignes de grille (211) comprend : la réalisation du premier traitement laser uniquement sur les régions de traitement laser (I) sur les deux côtés de la première ligne de grille respective.

3. Procédé de préparation de la cellule solaire selon la revendication 2, dans lequel dans la direction d'extension de la première ligne de grille respective, un rapport d'une longueur totale des régions de traitement laser (I) à une longueur totale des régions de non-traitement laser (II) va de 2:1 à 4:1.

4. Procédé de préparation de la cellule solaire selon la revendication 2 ou la revendication 3, dans lequel dans la direction d'extension de la première ligne de grille respective, une longueur d'une seule région de traitement laser des régions de traitement laser (I) va de 1 µm à 5 µm, et une longueur d'une seule région de non-traitement laser des régions de non-traitement laser (II) va de 3 µm à 7 µm.

5. Procédé de préparation de la cellule solaire selon l'une quelconque des revendications 1 à 4, dans lequel lors de la réalisation du premier traitement laser sur la première surface sur deux côtés de la première ligne de grille respective de la pluralité de premières lignes de grille, le procédé comprend en outre : la réalisation du premier traitement laser sur la première ligne de grille respective.

6. Procédé de préparation de la cellule solaire selon l'une quelconque des revendications 1 à 5, dans lequel la première surface comprend une pluralité de premières régions laser et une pluralité de secondes régions laser, dans lequel deux de la pluralité de premières régions laser sont situées sur les deux côtés de la première ligne de grille respective dans une direction perpendiculaire à une direction d'extension de la première ligne de grille respective, deux de la pluralité de secondes régions laser sont situées sur des côtés des deux premières régions laser éloignés de la première ligne de grille respective, et une projection orthogonale d'une seconde ligne de grille respective de la pluralité de secondes lignes de grille (212) sur la première surface est située dans une seconde région laser respective de la pluralité de secondes régions laser ;
la réalisation du premier traitement laser sur la première surface sur deux côtés de la première ligne de grille respective de la pluralité de premières lignes de grille (211) comprend : la réalisation du premier traitement laser sur la pluralité de premières régions laser ; et
après la réalisation du premier traitement laser, le procédé comprend en outre : la réalisation d'un second traitement laser sur la pluralité de secondes régions laser, et l'application d'un second courant inverse entre la pluralité de premières lignes de grille (211) et la pluralité de secondes lignes de grille (212), dans lequel une puissance laser du second traitement laser est supérieure à une puissance laser du premier traitement laser, et le second courant inverse est supérieur au premier courant inverse.

7. Procédé de préparation de la cellule solaire selon la revendication 6, dans lequel une première région laser respective des deux premières régions laser comprend des régions de traitement laser et des régions de non-traitement laser (II), qui sont agencées en alternance dans la direction d'extension de la première ligne de grille respective ;
la réalisation du premier traitement laser sur la pluralité de premières régions laser comprend : la réalisation du premier traitement laser uniquement sur les régions de traitement laser de la première région laser respective ;
la réalisation du second traitement laser sur la pluralité de secondes régions laser comprend : la réalisation du second traitement laser sur toutes les secondes régions laser.

8. Procédé de préparation de la cellule solaire selon la revendication 6, dans lequel dans la direction perpendiculaire à la direction d'extension de la première ligne de grille respective, une largeur d'une seule seconde région laser des secondes régions laser respectives est égale à une largeur de la seconde ligne de grille respective ; ou
dans lequel dans la direction perpendiculaire à la première ligne de grille respective, des largeurs des deux premières régions laser sur deux côtés des secondes régions laser respectives sont égales ;
optionnellement, dans lequel dans la direction perpendiculaire à la direction d'extension de la première ligne de grille respective, un rapport d'une largeur d'une première région laser respective des deux premières régions laser à une largeur de la seconde région laser respective va de 0,6 à 1,6 ;
optionnellement, dans lequel dans la direction perpendiculaire à la direction d'extension de la première ligne de grille respective, la largeur de la première région laser respective va de 60 µm à 100 µm.

9. Procédé de préparation de la cellule solaire selon l'une quelconque des revendications 1 à 8, dans lequel la puissance prédéfinie et le courant prédéfini sont obtenus par test d'une feuille de cellule de test ;
la feuille de cellule de test comprend une surface avant et une surface arrière opposées l'une à l'autre, des lignes de grille avant agencées sur la surface avant, et des lignes de grille arrière agencées sur la surface arrière, dans lequel des projections orthogonales des lignes de grille avant sur la surface avant chevauchent complètement des projections orthogonales des lignes de grille arrière sur la surface avant ;
la réalisation d'un traitement laser sur une surface sur deux côtés de chacune des lignes de grille avant de la feuille de cellule de test, et l'application d'un courant inverse entre les lignes de grille avant et les lignes de grille arrière, pour provoquer le claquage de jonctions PN entre les lignes de grille avant et les lignes de grille arrière, dans lequel une puissance laser et le courant inverse correspondant au claquage des jonctions PN sont obtenus en tant que puissance prédéfinie et courant prédéfini.

10. Procédé de préparation de la cellule solaire selon l'une quelconque des revendications 1 à 9, dans lequel le rapport de la puissance laser du premier traitement laser à la puissance prédéfinie est de 1, et le rapport du premier courant inverse au courant prédéfini est supérieur à 1 ; ou
le rapport du premier courant inverse au courant prédéfini est de 1, et le rapport de la puissance laser du premier traitement laser à la puissance prédéfinie est supérieur à 1.

11. Procédé de préparation de la cellule solaire selon la revendication 1, dans lequel des distances d'une projection orthogonale de toute seconde ligne de grille respective de la pluralité de secondes lignes de grille (212) sur la première surface à des projections orthogonales de deux premières lignes de grille adjacentes (211) sur la première surface sont égales.

12. Procédé de préparation de la cellule solaire selon la revendication 1, dans lequel un nombre de la pluralité de secondes lignes de grille (212) est le double d'un nombre de la pluralité de premières lignes de grille, et toute première ligne de grille respective de la pluralité de premières lignes de grille est agencée à une position correspondante au milieu de deux secondes lignes de grille adjacentes de la pluralité de secondes lignes de grille (212) à des intervalles des deux secondes lignes de grille adjacentes ; ou
dans lequel un nombre de la pluralité de secondes lignes de grille (212) est égal à un nombre de la pluralité de premières lignes de grille (211), et toute première ligne de grille respective de la pluralité de premières lignes de grille (211) est située dans une région entre deux secondes lignes de grille adjacentes de la pluralité de secondes lignes de grille (212).

13. Procédé de préparation de la cellule solaire selon la revendication 2, dans lequel dans une direction perpendiculaire à la direction d'extension de la première ligne de grille respective, une largeur d'une seule région de traitement laser des régions de traitement laser est égale à un espacement entre deux premières lignes de grille adjacentes quelconques de la pluralité de premières lignes de grille (211) ; ou
dans lequel dans une direction perpendiculaire à la direction d'extension de la première ligne de grille respective, une largeur d'une seule région de traitement laser des régions de traitement laser est inférieure ou égale à la moitié d'un espacement entre deux premières lignes de grille adjacentes quelconques de la pluralité de premières lignes de grille (211).
